# EUROPEAN PATENT SPECIFICATION

(11) **EP 2 463 927 B1**
(45) Date of publication and mention of the grant of the patent: **21.08.2013**
(21) Application number: 11183558.3
(22) Date of filing: 30.09.2011
(51) Int. Cl.: H01L 51/30, H01L 51/00

(54) **Material for organic electronic device and organic electronic device**
Material für eine organische elektronische Vorrichtung und organische elektronische Vorrichtung
Matériau pour dispositif électronique organique et dispositif électronique organique

(30) Priority: 08.12.2010 EP 10194120
(43) Date of publication of application: 13.06.2012
(73) Proprietor: Novaled AG, 01307 Dresden (DE)
(72) Inventor: Dorok, Sascha, 01099 Dresden (DE); Limmert, Michael, 01277 Dresden (DE); Lux, Andrea, 01277 Dresden (DE); Rothe, Carsten, 01326 Dresden (DE)
(74) Representative: Bittner, Thomas L.

(56) References cited:
- US-A1- 2005 208 333
- US-A1- 2010 164 371
- L. AUBOUY ET AL: "Molecular engineering to improve the charge carrier balance in single-layer silole-based OLEDs", NEW JOURNAL OF CHEMISTRY, vol. 33, 27 April 2009 (2009-04-27), pages 1290-1300, XP007916916,

## Description

The present invention relates to a material for an organic electronic device, an organic electronic device and a process for preparing thereof.

Organic electronic devices, such as organic semiconductors, can be used to fabricate simple electronic components, e.g. resistors, diodes, field effect transistors, and also optoelectronic components like organic light emitting devices (e.g. organic light emitting diodes (OLED)), and many others. The industrial and economical significance of the organic semiconductors and their devices is reflected in the increased number of devices using organic semiconducting active layers and the increasing industry focus on the subject.

OLEDs are based on the principle of electroluminescence in which electron-hole pairs, so-called excitons, recombine under the emission of light. To this end the OLED is constructed in the form of a sandwich structure wherein at least one organic film is arranged as active material between two electrodes, positive and negative charge carriers are injected into the organic material and a charge transport takes place from holes or electrons to a recombination zone (light emitting layer) in the organic layer where a recombination of the charge carrier to singlet and/or triplet excitons occurs under the emission of light. The subsequent radiant recombination of excitons causes the emission of the visible useful light emitted by the light-emitting diode. In order that this light can leave the component at least one of the electrodes must be transparent. Typically, a transparent electrode consists of conductive oxides designated as TCOs (transparent conductive oxides), or a very thin metal electrode; however other materials can be used. The starting point in the manufacture of an OLED is a substrate on which the individual layers of the OLED are applied. If the electrode nearest to the substrate is transparent the component is designated as a "bottom-emitting OLED" and if the other electrode is designed to be transparent the component is designated as a "top-emitting OLED". The layers of the OLEDs can comprise small molecules, polymers, or be hybrid.

The most robust and efficient OLEDs are OLEDs comprising doped layers. By electrically doping hole transport layers with a suitable acceptor material (p-doping) or electron transport layers with a donor material (n-doping), respectively, the density of charge carriers in organic solids (and therefore the conductivity) can be increased substantially. Additionally, analogous to the experience with inorganic semiconductors, some applications can be anticipated which are precisely based on the use of p- and n-doped layers in a component and otherwise would be not conceivable. The use of doped charge-carrier transport layers (p-doping of the hole transport layer by admixture of acceptor-like molecules, n-doping of the electron transport layer by admixture of donor-like molecules) in organic light-emitting diodes is, e.g., described in US 2008/203406 and US 5,093,698.

US 2005/0208333 discloses arylamines as hole transporting materials in OLEDs.

All references to n-dopant or p-dopant in this patent application refer preferentially to the electrical dopants as described in the literature. The words dopant, doped, or doping refers to any inclusion of a guest material in a matrix material, preferentially to improve the electrical conductivity.

Several operational parameters of the OLED are being constantly improved to enhance the overall power efficiency. One important parameter is the operation voltage which can be tuned by improving the transport of charge carriers and/or reducing energy barriers such as the injection barriers from the electrodes. Other organic devices, such as organic solar cells also require improving in efficiency, which nowadays, are at best at about 7%.

Like an OLED, an organic solar cell has a stack of organic layers between two electrodes. In a solar cell, there must be at least one organic layer responsible for the absorption of light and a interface which separates the excitons created by the absorption (photo-active). The interface can be a bi-layer heterojunction, a bulk-heterojunction, or can comprise more layers, e.g., in a step wise interface. Also sensitizing layers and others can be provided. For increased efficiency, a good charge carrier transport is required, in some device structures the transport regions must not absorb light, therefore transport layers and photo-active layers may comprise different materials. Also charge carrier and/or exciton blocking layers may be employed. Highest efficiency solar-cells are, nowadays, multi-layer solar cells, some device structures are stacked (multi-junction solar cells) and connected by a connecting unit (also called recombination layer); nevertheless, single junction solar cells could have a high performance if the right materials were found. Examples of devices are given in US2009217980, or in US2009235971.

In contrast to OLEDs and organic solar cells, transistors do not require doping of the entire semiconducting (channel) layer, because the concentration of available charge carriers is determined by an electric field supplied by a third electrode (gate electrode). However, conventional organic thin film transistors (OTFTs) require very high voltages to operate. There is a need to lower this operating voltage; such an optimization can be done, e.g. with appropriate injection layers.

Organic transistors are also called organic field-effect transistors. It is anticipated that a large number of OTFTs can be used for example in inexpensive integrated circuits for non-contact identification tags (RFID) but also for screen control. In order to achieve inexpensive applications, generally thin-layer processes are required to manufacture the transistors. In recent years performance features have been improved to such an extent that the commercialization of organic transistors is foreseeable. For example, in OTFTs high field-effect mobilities of up to 6 cm²/Vs for electrons on the basis of C60 fullerene and up to 5,5 cm²/Vs for holes on the basis of pentacene (Lee et al., Appl. Lett. 88, 162109 (2006)) have been reported. A typical organic field-effect transistor comprises an active layer of organic semiconducting material (semiconducting layer) material which during the operation forms an electrical conduction channel, a drain and a source electrodes which exchange electrical charges with the semiconducting layer, and a gate electrode which is electrically isolated from the semiconducting layer by an dielectric layer.

There is a clear need to improve charge carrier injection and/or conductivity in organic electronic devices. Reducing or eliminating the barrier for charge injection between the electrode and the electron transport material (ETM) contributes strongly to enhancement of the device efficiency. Nowadays, there are two main approaches to reduce voltage and enhance efficiencies of organic electronic devices: improvement of the charge carrier injection and improvement of the conductivity of the transport layers. Both approaches can be used in combination.

For instance, US 7,074,500 discloses a component structure for an OLED which leads to a greatly improved charge carrier injection from the electrodes into the organic layers. This effect is based on considerable band bending of the energy levels in the organic layer at the interface to the electrodes, as a result of which injection of charge carriers on the basis of a tunnel mechanism is possible. The high conductivity of the doped layers also prevents the voltage drop which occurs there during operation of the OLED. The injection barriers which may occur in OLEDs between the electrodes and the charge carrier transport layers are one of the main causes for an increase in the operating voltage compared to the thermodynamically justified minimum operating voltages. For this reason, many attempts have been made to reduce the injection barriers, for example by using cathode materials with a low work function, for example metals such as calcium or barium. However, these materials are highly reactive, difficult to process and are only suitable to a limited extent as electrode materials. Moreover, any reduction in operating voltage brought about by using such cathodes is only partial. Metals having low work function, in particular alkali metals such as Li and Cs, are often used either as the cathode material or the injection layer to promote electron injection. They have also widely been used as dopants in order to increase the conductivity of the ETM, US6013384, US6589673. Metals such as Li or Cs provide a high conductivity in matrixes which are difficult to dope otherwise (e.g. BPhen, Alq3).

However, the use of low work function metals has several disadvantages. It is well known that the metals can easily diffuse through the semiconductor, eventually arriving at the optically active layer quenching the excitons, thereby lowering the efficiency of the device and the lifetime. Another disadvantage is their high susceptibility to oxidation upon exposure to air. Therefore, devices using such metals as dopants, injection or cathode material require rigorous exclusion of air during production and rigorous encapsulation afterwards. Another well known disadvantage is that the molar doping concentration of the dopant must be close to 1:1, which strongly increase the undesired absorption of light of the transport layers. Yet another problem is their very high volatility leading to cross-contamination in the device assembling process making their use in device fabrication tools less attractive.

Another approach to facilitate metals as n-dopants and/or injection materials for ETM is the use of electron rich metal complexes and metal organic compounds, such as W(hpp)2 or Co(Cp*)2 (US2009/0212280, WO2003/088271) which have similar or slightly less doping / injecting ability in comparison with alkaline earth metals. Due to their still high enough electron donating capability, they are also undergoing rapid decay upon exposure to air, making their handling in device production difficult.

Yet another approach is the use of compounds of low work function metals in which the metal occurs in its oxidized stage. Inorganic compounds like LiF, NaCl, etc. have been used as well; these compounds do achieve some improvement, but cannot be used for devices with highest performance.

Hence, although compounds of alkaline earth metals are air stable, they are limited to the use as cathode material and only work in the injection approach, but not as a dopant which increases the conductivity of the matrix material.

Therefore, it is very desirable to provide materials which possess high doping/charge injection capability allowing for highly efficient organic electronic devices substantially preserving the long-term stability of the device and which are infinitely stable in air.

It is therefore an objective of the present invention to provide an organic electronic device, preferably incorporating a dopant or a charge injecting material, which overcomes state of the art limitations mentioned above and having improved performance compared to electronic devices of the prior art. Further, it is an object to provide a process for preparing such an organic electronic device.

The first object is achieved by an organic electronic device comprising at least one substantially organic layer comprising a chemical compound according to formula (I): 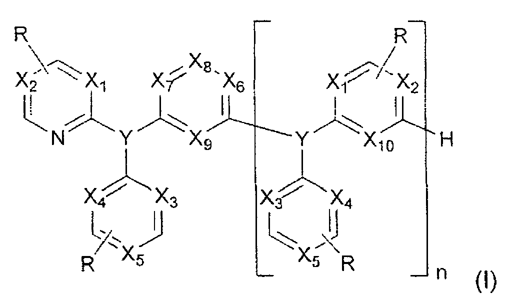 wherein n is an integer of from 1 to 5, more preferably 1 or 2;
each X₁-X₇ is independently selected from N and CR;
X₈ is N or CR'
X₉ is N or CH;
X₁₀ is N or CH;
each Y is independently selected from N, CR and SiR; and
each R is independently selected from H, linear and branched alkyl, preferably C₁-C₆ alkyl, aryl, preferably C₆-C₂₀-aryl, and heteroaryl, preferably C₅-C₂₀ heteroaryl;
R' is selected from H, linear and branched alkyl, preferably C₁-C₆ alkyl, and aryl, preferably C₆-C₂₀ aryl;
and, in case Y is CR, R is different from H, wherein the organic layer is placed in the device as defined in claim 1.

Compounds according to formula I with n=1 or 2 are preferred, because of further improved thermal morphological stability.

Preferably, X₃ is N.

Preferably each X₁-X₇ is independently selected from N and CR.

Where suitable, alkyl, methyl, aryl and heteroaryl may be substituted.

In an even preferred embodiment, X₈ is N. It may be also preferred that R' is not H or CH₃.

Suitable aryls and heteroaryls are biphenyl, naphthalenyl, anthracenyl, phenanthrenyl, pyrenyl, fluorenyl, benzooxazolyl.

Someone skilled in the art is aware that the substituent R at each ring of the compound according to formula (I) or (II) can be at any possible ring position. Further, the presence of more than one R at each ring is possible.

Organic electronic devices according to the present invention are preferably organic light emitting devices or solar cells. Within inventive organic electronic devices, the chemical compound according to formula (I) or (II) can be most preferably used as dopant to increase the conductivity in an electron transport layer, optionally together with use of a metal and an electron transport material, as an injection layer material, or as a material for a pn junction.

A preferred subclass of compounds is: 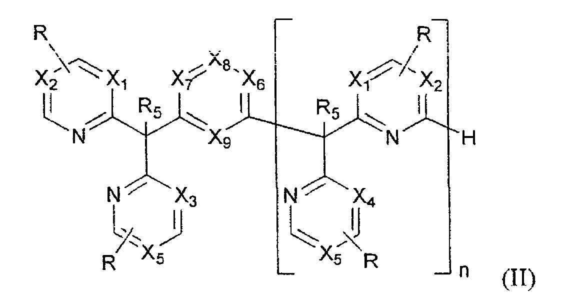 wherein
each X₁-X₇ is independently selected from N, and CR, preferably X₇ and X₆ = CH;
X₈ is independently selected from N and CR₆, with R₆ independently selected from linear and branched alkyl, preferably C₁-C₆ alkyl, and aryl, preferably C₆-C₂₀ aryl;
X₉ is N or CH;
each R is independently selected from H, linear and branched alkyl, preferably C₁-C₆-alkyl, aryl, preferably C₆-C₂₀-aryl, and heteroaryl, preferably C₅-C₂₀ heteroaryl, preferably H; and
R₅ is alkyl, preferably preferably C₁-C₆-alkyl;
n is an integer of from 1-5, preferably 1 or 2.

Preferably, R' and R₆ are not substituted by amine substituents, even more preferred R' and R₆ are not substituted by aryl amine substituents, or any substituent at all.

Preferred chemical compounds according to formula (I) or (II) can be selected from the following list of compounds (1)-(68)

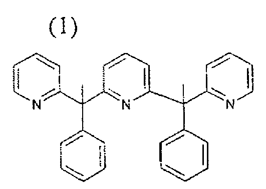

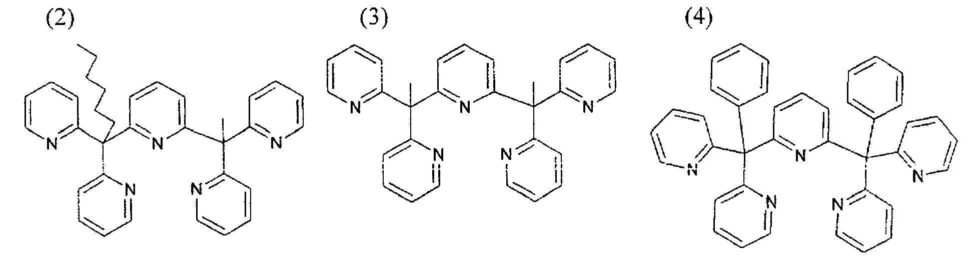

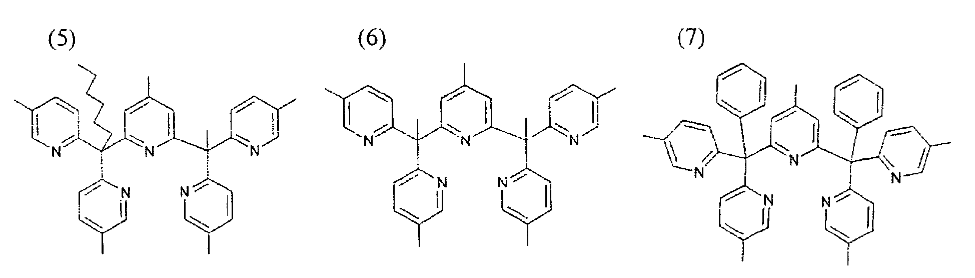

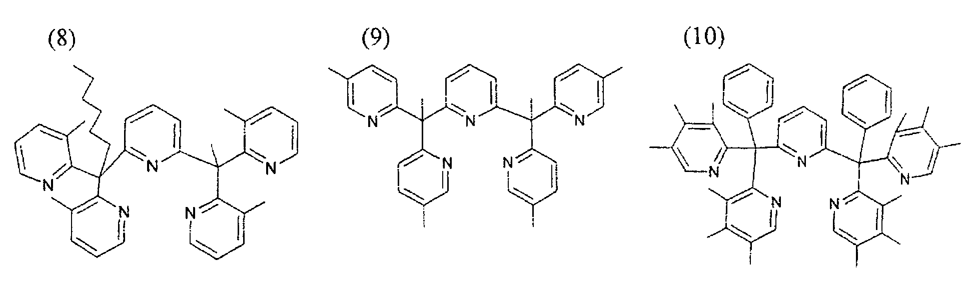

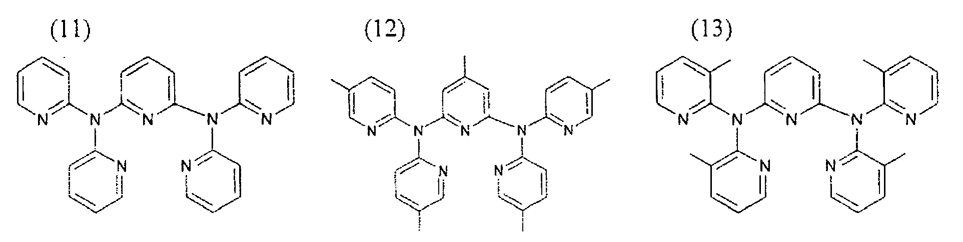

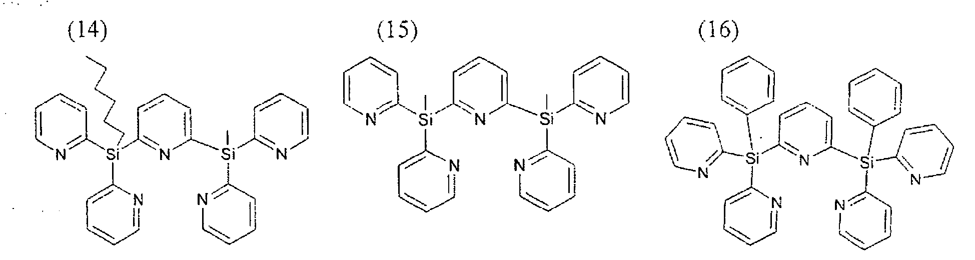

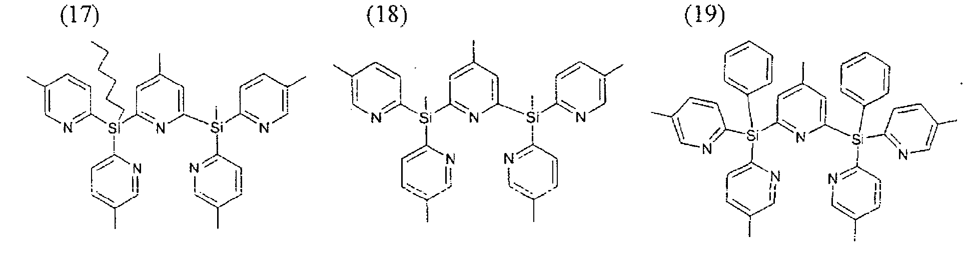

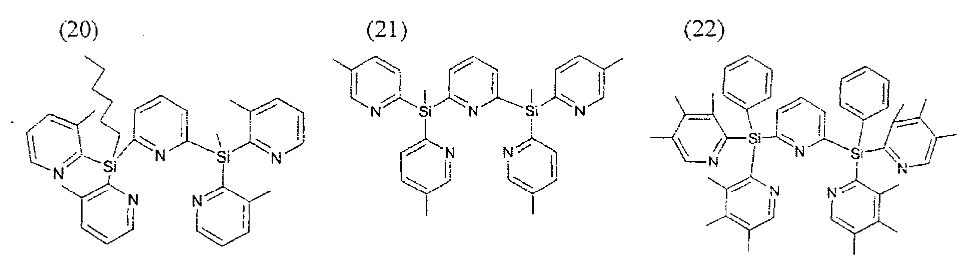

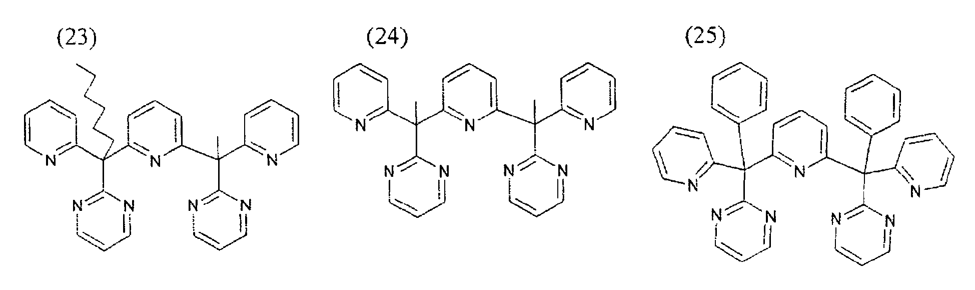

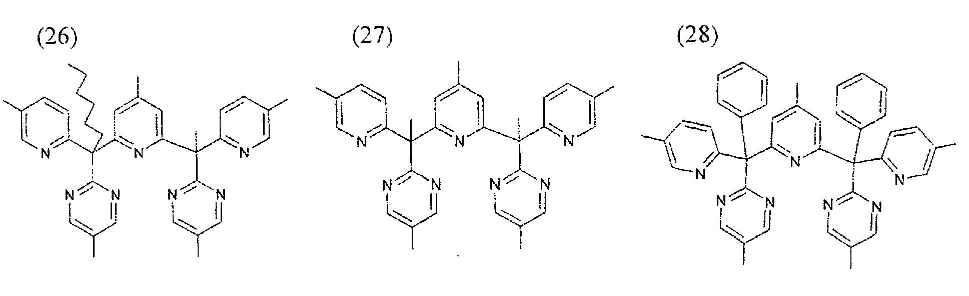

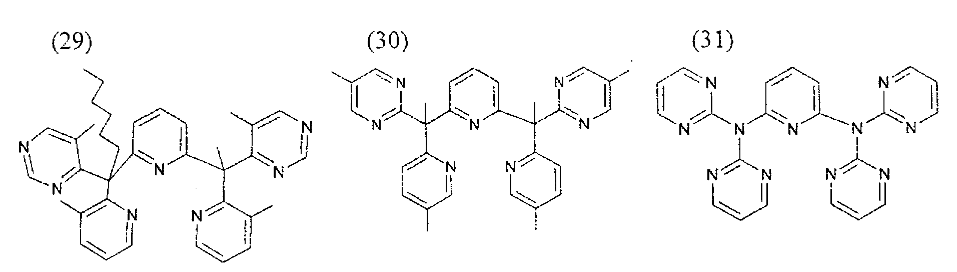

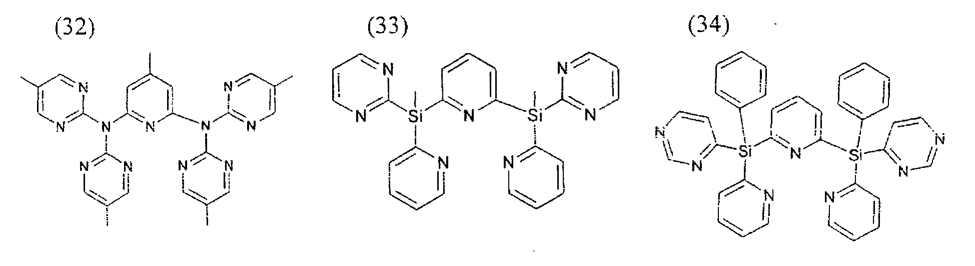

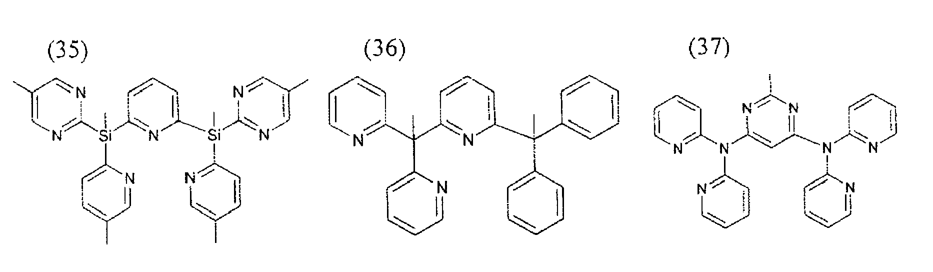

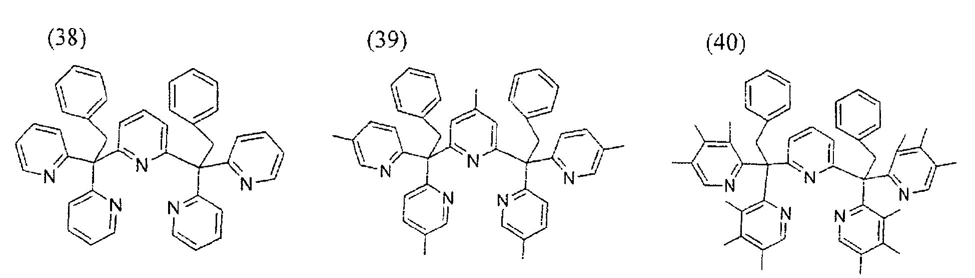

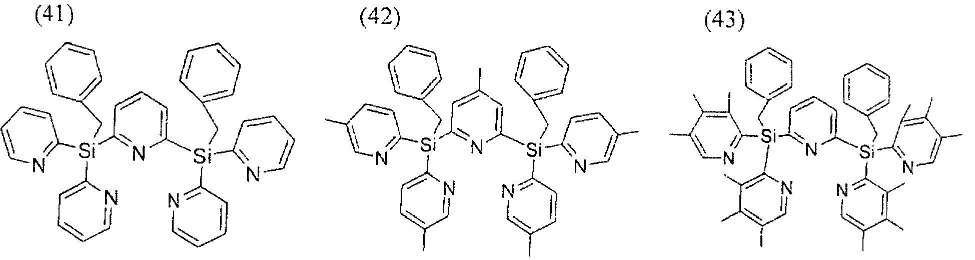

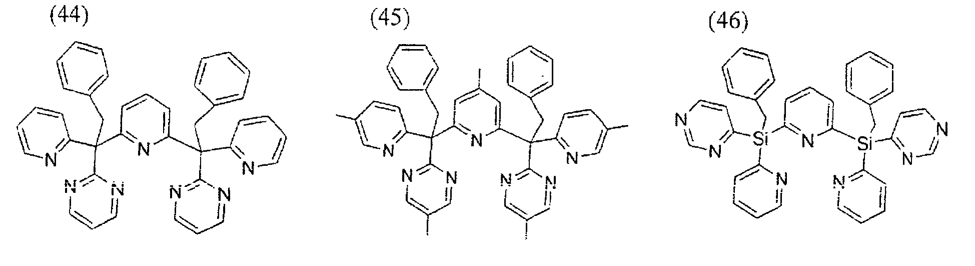

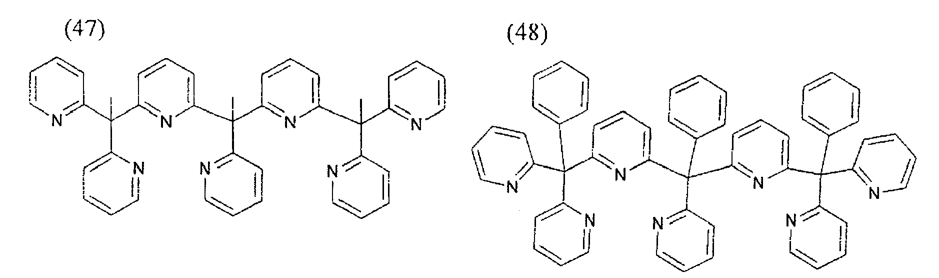

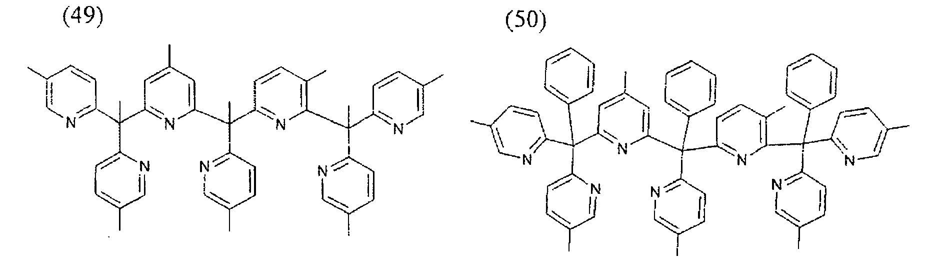

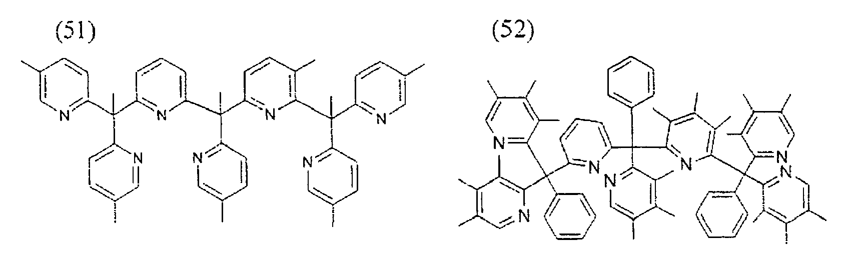

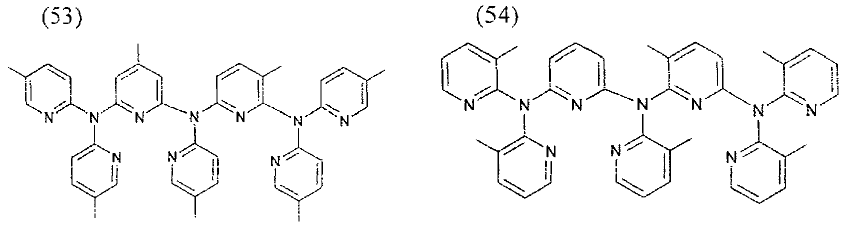

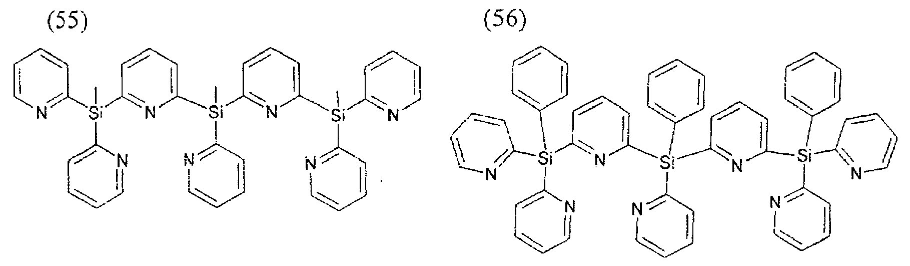

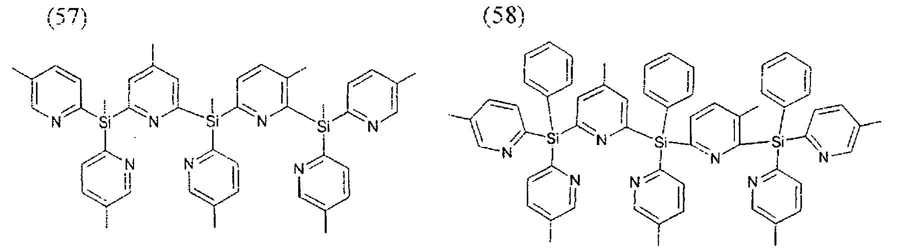

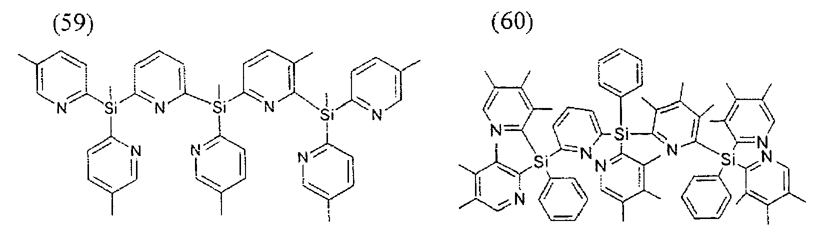

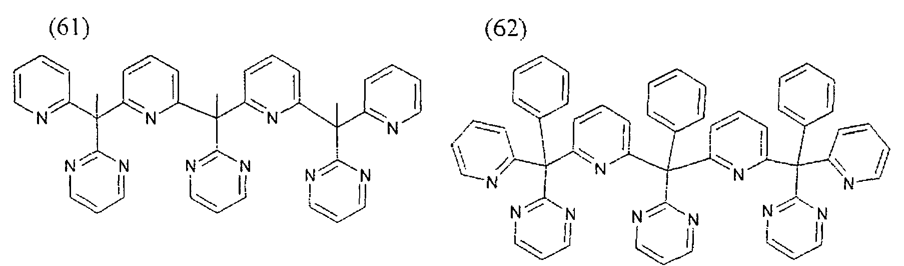

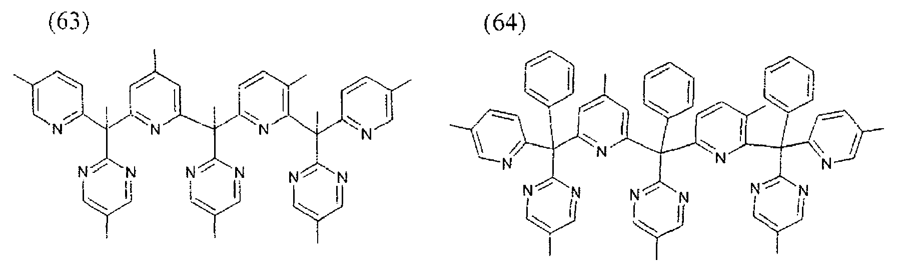

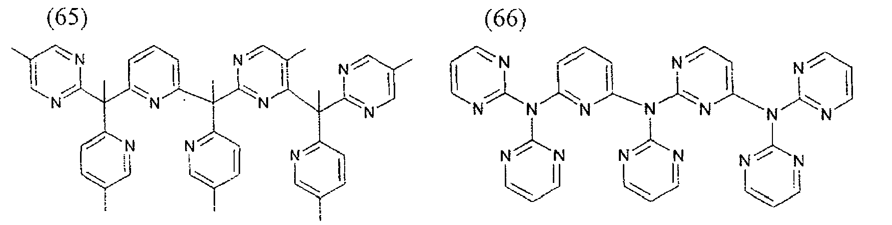

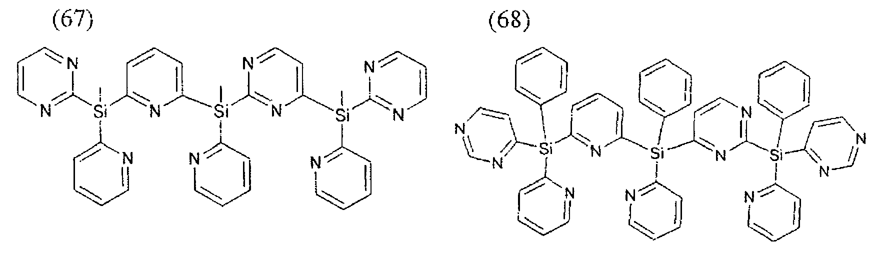

Preferably the compound according to formula (I) or (II) is used in transport and/or injection layers.

These compounds according to formula (I) or (II) have a high energy band-gap and are not fully conjugated. The chemical compounds according to formula (I) or (II) are air-stable and capable to be evaporated without decomposition. They are also soluble in a variety of solvents. This makes the compounds according to formula (I) or (II) particularly easy to use in manufacturing processes.

In a further development of the invention, the substantially organic layer comprises at least one metal or a metal ion, preferably interacting with the chemical compound according to formula (I) or (II), wherein the metal or metal ion is selected from Ag, Al, Mg, Ba, Ca, Yb, In, Zn, Sn, Sm, Bi, Eu, Li, more preferably from Al, Mg, Ca, Ba and even more preferably selected from Al or Mg.

It is preferred that the molar ratio of metal: compound according to formula (I) or (II) is 1:1 or less, so that there is no excess metal in the layer.

Preferably, the cathode comprises a metal selected from Ag, Al, Mg, Ba, Ca, Yb, In, Zn, Sn, Sm, Bi, Eu, Li, more preferably from Al, Mg, Ca, Ba and even more preferably selected from Al or Mg. Preferred is also a cathode comprising an alloy of Mg and Ag.

In one preferred embodiment, the cathode is a top electrode and the anode is a bottom electrode, wherein the bottom electrode is closer to the substrate than the top electrode.

The substantially organic layer may further comprise an electron transport material. The electron transport material constitutes preferably 10wt% or more of the substantially organic layer. This is to allow charge transport through the layer. More preferred is 40% or more. For an electron transport layer, it is more preferred that the electron transport material is the main component of the layer.

Suitable matrix materials as electron transport materials can be as follows:
As matrix materials for electron transport layers, use may be made for example of fullerenes, such as for example C60, oxadiazole derivatives, such as for example 2-(4-biphenyl)-5-(4-tert-butylphenyl)-1,3,4-oxadiazole, quinoline-based compounds such as for example bis(phenylquinoxalines), or oligothiophenes, perylene derivatives, such as e.g. perylenetetra-carboxylic acid dianhydride, naphthalene derivatives such as e.g. naphthalenetetracarboxylic acid dianhydride, or other electron transport materials.
As matrix materials for electron transport layers, use may also be made of quinolinato complexes, for example of aluminum or other main group metals, it also being possible for the quinolinato ligand to be substituted. In particular, the matrix material may be tris(8-hydroxy-quinolinato) aluminum. Other aluminum complexes with O and/or N donor atoms may optionally also be used. The quinolinato complexes may contain for example one, two or three quinolinato ligands, the other ligands preferably complexing with O and/or N donor atoms on the central atom, such as for example the following Al complex. 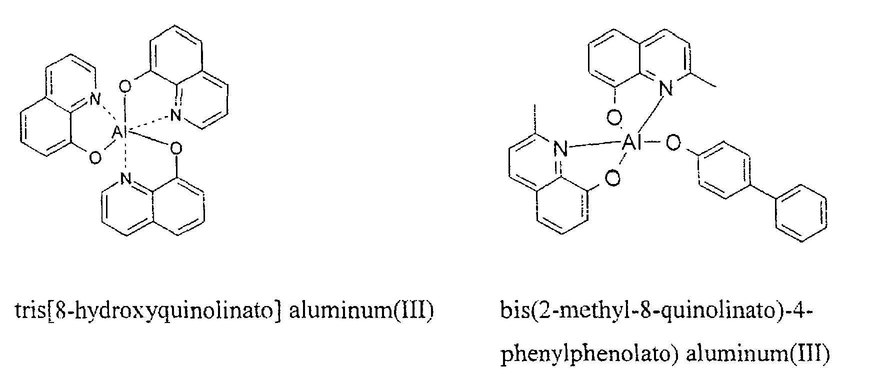
As matrix materials, use may also be made of heteroaromatics such as, in particular, triazole derivatives, optionally also pyrroles, imidazoles, triazoles, pyridines, pyrimidines, pyridazines, quinoxalines, pyrazino-quinoxalines and the like. The heteroaromatics are preferably substituted, in particular aryl-substituted, for example phenyl- or naphthyl-substituted. In particular, use may be made of the following triazole as matrix material.

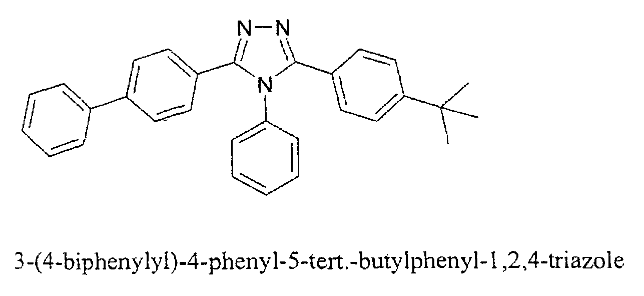

Other compounds suitable as electron transport materials are compounds from:
- US2007/0138950, preferentially, compounds (1) and (2) on page 22, compounds (3), (4), (5), (6), and (7) on page 23, compounds (8), (9), and (10) on page 25, and compounds (11), (12), (13), and (14) on page 26, which compounds are incorporated herein by reference;
- US2009/0278115 A1, preferentially, compounds (1) and (2) on page 18, which compounds are incorporated herein by reference;
- compounds from US2007/0018154, preferentially the compounds of claim 10, formula 1-1, 1-2, 1-3, 1-4, 1-5, 1-6 on page 19, 1-7 to 1-146 on pages 20 to 26. Compounds from US2008/0284325 Al, preferentially compounds on page 4: 2-(4-(9,10-diphenylanthracen-2-yl)phenyl)-1-phenyl-1H-benzo [d]imidazole, 2-(4-(9,10-di([1,1'-biphenyl]-2-yl) anthracen-2-yl)phenyl)-1-phenyl-1H-benzo [d]imidazole, 2-(4-(9,10-di(naphthalen-1-yl) anthracen -2-yl) phenyl) -1-phenyl-1H-benzo[d]imidazole, 2-(4-(9,10-di(naphthalen-2-yl) anthracen-2-yl) phenyl)-1-phenyl-1H-benzo[d] imidazole, 2-(4-(9,10-di([1,1':3',1"-terphenyl]-5'-yl) anthracen
- 2-yl)phenyl)-1-phenyl-1H-benzo[d]imidazole, and the compound on page 5, which compounds are incorporated herein by reference;
- naphthacene derivatives from US2007/0222373, preferentially, compounds (A-1) and (A-2) from page 17, compounds (A-3) from page 18 and (A-4) from page 19, which compounds are incorporated herein by reference;
- compounds from US2008/0111473, preferentially, compound 1 on page 61, compound 2 on page 62, compounds 3 and 4 on page 63, compound 5 on page 64, and compound 6 on page 65, which compounds are incorporated herein by reference;
- compound H-4 from page 20, and compounds (1) and (2) of page 12 of US2010/0157131, which compounds are incorporated herein by reference;
- compounds from US2010/0123390, according to general formula (1), preferentially, compounds H4, H5 p.21, H7 p.22, H11, H12, H13 p.23, H16, and H18 p.24, which compounds are incorporated herein by reference;
- US2007/0267970, preferentially 2-([1,1'-biphenyl]-4-yl)-1-(4-(10-(naphthalen-2-yl) anthracen-9-yl)phenyl)-2,7a-dihydro-1H-benzo[d]imidazole (compound 1), 2-([1,1'-biphenyl]-2-yl)-2-(4-(10-(naphthalen-2-yl)anthracen-9-yl)phenyl)-2,7a-dihydro-1H-benzo[d]imidazole (compound 2). Compound (C-1) from US2007/0196688, p. 18, which is incorporated herein by reference;

Additional known electron transport materials can be used such as: 1,3,5-Tris(1-phenyl-1H-benzimidazol-2-yl)benzene; 2-(4-Biphenylyl)-5-phenyl-1,3,4-oxadiazol; Tris(2,4,6-trimethyl-3-(pyridin-3-yl)phenyl)borane; 4,4'-bis(4,6-diphenyl-1,3,5-triazin-2-yl)biphenyl; 2,2'-Dipyrenyl-9,9-spirobifluorene; 9,9-Bis[4-(pyrenyl)phenyl]fluorine; 2,2'-Bi(9,10-diphenylanthracene); Triphenylphosphinoxid; 14-phenyldibenzo[a,j]acridine; 2,7-Di-pyrenyl-9,9-spirobifluorene; 7-(naphthalen-2-yl)dibenzo[c,h]acridine; rubrene; phenyldi(pyren-1-yl)phosphine oxide; athracene.

Other preferred compounds as matrix materials for the electron transport layer are phenanthrolines and substituted phenanthrolines such as 4,7-diphenyl-1,10-phenanthroline, 2,9-dimethyl-4,7-diphenyl-1,10-phenanthroline, 2,9-di(naphthalen-2-yl)-4,7-diphenyl-1,10-phenanthroline, 4-(naphthalen-1-yl)-2,7,9-triphenylpyrido[3,2-h]quinazoline, 2,9-bis(4-methoxyphenyl)-4,7-diphenyl-1,10-phenanthroline, 2,9-di(naphthalen-1-yl)-4,7-diphenyl-1,10-phenanthroline, the compounds according to formula I on page 3 of US 2009/0001327 Al , compounds according to formulas II and III on page 3 of US 2009/0001327 A1, compounds according to "Struktur 8" on page 5 of EP2072517 A1 compounds according to the formula on paragraph 28 on page 5 of EP2194055 A1, which compounds and references are all incorporated herein by reference.

Particularly preferred the electron transport material is selected from: 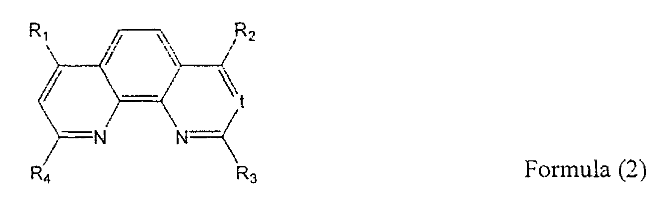
- wherein R1 - R4 are independently selected from H, C1-C20-Alkyl, branched C4-C20-alkyl or C3-C20-cycloalkyl, C1-C20 alkenyl, C1-C20 alkinyl, aryl preferably selected from phenyl, tolyl, biphenylyl, naphthyl, or heteroaryl preferably selected from pyridyl, pyrimidinyl, quinolinyl, pyrazinyl, thiophenyl, furanyl, benzothiophenyl, benzofuranyl;
- wherein the structural element t is selected from CH, CR1, N, CCN.

Particularly preferred, the electron transport material is selected from: 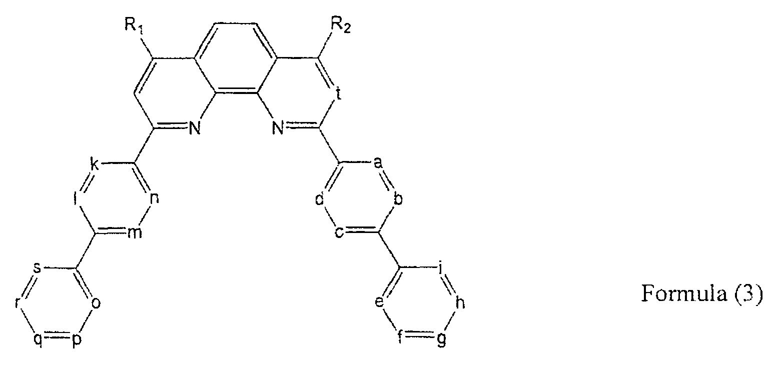
- wherein R1 and R2 are independently selected from H, C1-C20-Alkyl, branched C4-C20-alkyl or C3-C20-cycloalkyl, C1-C20 alkenyl, C1-C20 alkinyl, aryl preferably selected from phenyl, tolyl, biphenylyl, naphthyl, or heteroaryl preferably selected from pyridyl, pyrimidinyl, quinolinyl, pyrazinyl, thiophenyl, furanyl, benzothiophenyl, benzofuranyl;
- wherein the structural elements a-s are independently selected from CR3 or N wherein R3 is selected from H, C1-C20-alkyl or branched C4-C20-alkyl, C3-C20-cycloalkyl alkenyl with C1-C20, alkinyl with C1-C20, aryl, heteroaryl, -hal, -CN, -NO2, -NR4R5 wherein R4, R5 are independently selected from H, C1-C20-alkyl or branched C4-C20-alkyl, C1-C20-cycloalkyl, alkenyl with C1-C20, alkinyl with C1-C20, aryl or heteroaryl, -OR6 or SR6 wherein R6 is selected from H, C1-C20-alkyl or branched C4-C20-alkyl C3-C20-cycloalkyl, alkenyl with C1-C20, alkinyl with C1-C20, aryl or heteroaryl, COOR7 wherein R7 is selected from H, C1-C20-alkyl or branched C4-C20-alkyl, C3-C20-cycloalkyl, alkenyl with C1-C20, alkinyl with C1-C20, aryl or heteroaryl;
- wherein a=b, l=k, f=g, h=i, p=q, r=s can be replaced by -O-, -S-, NR8 wherein R8 is selected from H, C1-C20-alkyl or branched C4-C20-alkyl, C3-C20-cycloalkyl, alkenyl with C1-C20, alkinyl with C1-C20, aryl or heteroaryl;
- wherein the structural element t is selected from CR3.

Preferred examples of an electron transport material are as follows: 2,9-di([1,1'-biphenyl]-4-yl)-4,7-di-p-tolyl-1,10-phenathroline; 2,9-di(phenanthren-2-yl)-4,7-diphenyl-1,10-phenanthroline; 2,9-di([1,1':4',1"-terphenyl]-4-yl)-4,7-diphenyl-1,10-phenanthroline; 2,9-bis(9,9-dimethyl-9H-fluoren-2-yl)-4,7-diphenyl-1,10-phenanthroline; 2,9-bis(4'-(tert-butyl)-[1,1'-biphenyl]-4-yl)-4,7-di-p-tolyl-1,10-phenanthroline; 2,9-di([1,1':4',1"-terphenyl]-4-yl)-4,7-di-p-tolyl-1,10-phenanthroline; 2,9-bis(4'-(tert-butyl)-[1,1'-biphenyl]-4-yl)-4,7-diphenyl-1,10-phenanthroline; 2,4,7,9-tetra([1,1'-biphenyl]-4-yl)-1,10-phenanthroline; 2,9-di([1,1'-biphenyl]-4-yl)-4,7-di(naphthalen-1-yl)-1,10-phenanthroline; 2,9-di(1,1'-biphenyl]-4-yl)-4,7-di(naphthalen-2-yl)-1,10-phenanthroline; 2,9-di([1,1'-biphenyl]-4-yl)-4,7-bis(4-(thiophen-2-yl)phenyl)-1, 10-phenanthroline; 2,9-di([1,1'-biphenyl]-4-yl)-4,7-bis(4-(pyrimidin-2-yl)phenyl)-1, 10-phenanthroline.

The organic electronic device may additionally comprise a polymer semiconducting layer.

Most preferably, the organic electronic device is a solar cell or a light emitting diode.

The organic electronic device may be also a field effect transistor comprising a semiconducting channel, a source electrode, and a drain electrode, the substantially organic layer being provided inbetween the semiconducting channel and at least one of the source electrode and the drain electrode.

In a further most preferred embodiment, the substantially organic layer comprising the chemical compound according to formula (I) or (II) is an electron injection layer and/or a n-doped electron transport layer.

The second object is achieved by a process for preparing an inventive organic electronic device wherein the substantially organic layer comprising a chemical compound according to formula (I) or (II) is deposited on a first other layer, and a second other layer is deposited on the substantially organic layer, a cathode being deposited on the substantially organic layer comprising the chemical compound according to formula (I) or (II).

Preferably, the substantially organic layer may be evaporated, preferably co-evaporated with metal and/or electron transport material.

Alternatively, the substantially organic layer is formed from a solution.

In other words, any layers of the inventive organic electronic device, especially the substantially organic layer can be deposited by known techniques, such as vacuum thermal evaporation (VTE), organic vapour phase deposition, laser induced thermal transfer, spin coating, blade or slit coating, inkjet printing, etc. A preferred method for preparing the organic electronic device according to the invention is vacuum thermal evaporation.

Surprisingly, it was found that the inventive organic electronic device overcomes disadvantages of prior art devices and has in particular an improved performance compared to electronic devices of the prior art, for example with regard to efficiency.

Organic electronic devices according to the invention are also preferred having connecting units. Multiple stacks of organic layers comprising an optoelectronic-active unit such as an emitter unit of an OLED or an absorbing unit of an organic solar cell can be stacked upon each other to form a tandem (in case of 2 units) or stacked device (in case of 2 or more units). A connecting unit must be provided between each optoelectronic-active unit, many different approaches for such connecting units are known: doped organic pn junctions are described in US 2009045728; pn junctions with a metal interlayer are shown in US 2004227460 and US 2007205411; completely inorganic junctions are described in US 2006214565, US 2006250079, and US 2006227531. Such connecting units are also called pn junctions, charge generation layer when used in OLEDs; or charge recombination layer when used in solar cells. There is no complete description about how such a connecting unit works, for some structures it is possible that the working principle is similar to a tunnel junction. A connecting unit can also be used between an electrode and an optoelectronic-active unit, as disclosed e.g. in EP 1 808 910.

Organic electronic devices according to the invention are preferred having connecting units (pn junctions) utilizing the chemical compound according to formula (I) or (II) as dopant1 as follows:
dopant1 :ETL/p-dopant/HTL
ETL (with or without dopant1) / dopant1 :/HTL
(with or without dopant1) ETL/p-doped HTL
dopant1 :ETL/p-dopant/HTL
(with or without dopant1)ETL/ dopant1/p-doped HTL
(with or without dopant1)ETL/p-doped HTL
dopant1:ETL/ HTL
dopant1:ETL/p-doped HTL

Additionally, it is preferred that the substantially organic layer is present in a pn junction, wherein the organic layer is used as interlayer (i) as follows:
ETL/i/p-dopant/HTL
ETL/n-dopant/i/HTL
ETL/i/p-doped HTL
n-doped ETL/i/p-dopant/HTL
ETL/n-dopant/i/p-doped HTL
ETL/i/p-doped HTL
n-doped ETL/i/HTL
n-doped ETL/i/p-doped HTL

It is also preferred to use the substantially organic layer in pn junctions in combination with a metal or metal ion in one of the layers. The metal or metal ion in the pn junction is selected from Ag, Al, Mg, Ba, Ca, Yb, In, Zn, Sn, Sm, Bi, Eu, Li, more preferably from Al, Mg, Ca, Ba and even more preferably selected from Al or Mg.

A preferred pn junction comprises the layer structure: dopant1 (mixed or preferentially pure layer) / thin metal layer (pure layer with thickness < 5 nm);

In one embodiment, the combination of the substantially organic layer with a metal or metal ion is carried out by mixing the metal into at least one of the following layers: the ETL and layer comprising dopant. In another preferred embodiment, the ETL and/or layer comprising dopant are formed adjacent to a thin metal layer (thickness 0.5 nm to 5 nm).

### Injection layer

In a preferred embodiment, the substantially organic layer, having the compound according to formula (1) or (II) as its main component, is adjacent to a cathode, preferably between a cathode and one of an ETL or HBL (hole blocking layer). The present invention has the advantages that, especially for non-inverted structures, the simplest form is also the one with a significantly improved performance compared to the structure not using an injection layer. The compound according to formula (I) or (II) can be used as a pure layer and is then preferably the only layer between an electron transporting layer (ETL or HBL) and the cathode. In this regard it is preferred for an OLED that the EML (emitter layer) and ETL matrix can be the same if the emission zone is far from the cathode. For a solar cell, the acceptor used in the optically active layer (such as C60) can be also a matrix for the ETL.

Such a pure layer as injection layer in organic electronic devices has a preferable thickness between 0,5 nm and 5 nm.

The thickness of the layer comprising the compound according to formula (I) or (II) is the nominal thickness, such thickness is usually calculated from the mass deposited on a certain area by the knowledge of the material's density. For example, with vacuum thermal evaporation VTE, the nominal thickness is the value indicated by the thickness monitor equipment. In reality, since the layer is not homogeneous and not flat at least at one interface, its final thickness is difficult to measure, in this case, the average value can be used.

The cathode in this regard is a conductive layer having optionally any surface modifications to modify its electrical properties, e.g. to improve its work-function or conductivity. Preferably, the cathode is a double layer, more preferably it is a single layer to avoid complexity.

In another preferred embodiment, the organic layer comprises the chemical compound according to formula (I) or (II) and a metal, this layer being then preferably adjacent to the cathode (and there is no other layer in between) and favors injection in the organic semiconductor.

### Semiconducting layer

It was further found that the compound according to formula (I) or (II) has a very high energy gap, therefore it can be mixed in small amounts in any semiconducting layer without modifying the semiconductor properties of that layer in a significant extent. Small amounts refer to concentrations of less than 30 mol-%, preferably less than 10 mol-%. In another preferred embodiment, the organic layer may be a transport or blocking layer such as a hole transport layer, an electron transport layer, a hole blocking layer or an electron blocking layer.

It is even preferred that the organic layer is an electron transport layer adjacent to the cathode and comprising the compound according to formula (I) or (II). If the ETL is directly adjacent to the cathode, this simplification has the advantage that no additional injection layer is required. Alternatively, an additional injection layer can be provided between the ETL and the cathode. This additional layer can be a layer having the chemical compound according to formula (I) or (II) as its main component, as already illustrated above. In one even preferred embodiment, the ETL is beneath the cathode (no other layer in between) wherein the cathode is the top electrode, which is formed after forming the ETL (non-inverted structure).

As already mentioned above, the substantially organic layer can be preferably an electron transport layer comprising a metal. Such a layer can be produced, for example, with vacuum thermal evaporation, simultaneously evaporating the electron transport material, the chemical compound according to formula (I) or (II) and a metal.

Such a layer increases the conductivity of electron transport layers significantly. Surprisingly, high conductivities were obtained using electron transport matrix materials which are otherwise not easily to be doped. The metals can be incorporated by many known techniques. An additional effect that was observed is an improvement of the OLED and also of the solar cell lifetime; and this improvement is better than the improvement expected only due to doping.

### Polymer hybrid OLED or solar cell

In a further preferred embodiment the substantially organic layer comprising the chemical compound according to formula (I) or (II) is used in combination with a polymer semiconductor, preferably between a cathode and a polymer layer, wherein the polymer layer preferably comprises the optoelectronic active region of the device (emitting region of an OLED or the absorbing region of a solar cell). All alternatives of layers comprising the chemical compound according to formula (I) or (II) or being composed thereof can be used in combination with that polymer layer. Exemplary alternative layers can be an injection layer being composed of the chemical compound according to formula (I) or (II), an injection layer comprising the chemical compound and a metal, an electron transport layer having the chemical compound with or without a metal. The electronic interface to the cathode is then strongly improved given the high electron injection capability of the chemical compound (I).

### Electrical doping

The invention can be used in addition to conventional doping of organic semiconducting layers. By using the term doping it is meant electrical doping as explained above. This doping can also be called redox-doping or charge transfer doping. It is known that the doping increases the density of charge carriers of a semiconducting matrix towards the charge carrier density of the undoped matrix. An electrically doped semiconductor layer also has an increased effective mobility in comparison with the undoped semiconductor matrix.

US2008227979 discloses in detail the doping of organic transport materials, also called matrix, with inorganic and with organic dopants. Basically, an effective electronic transfer occurs from the dopant to the matrix increasing the Fermi level of the matrix. For an efficient transfer in a p-doping case, the LUMO energy level of the dopant is preferably more negative than the HOMO energy level of the matrix or at least slightly more positive, not more than 0.5 eV, to the HOMO energy level of the matrix. For the n-doping case, the HOMO energy level of the dopant is preferably more positive than the LUMO energy level of the matrix or at least slightly more negative, not lower than 0.5 eV, to the LUMO energy level of the matrix. It is further more desired that the energy level difference for energy transfer from dopant to matrix is smaller than + 0.3 eV.

Typical examples of doped hole transport materials are: copperphthalocyanine (CuPc), which HOMO level is approximately -5.2 eV, doped with tetrafluoro-tetracyanoquinonedimethane (F4TCNQ), which LUMO level is about -5.2 eV; zincphthalocyanine (ZnPc) (HOMO = -5.2 eV) doped with F4TCNQ; a-NPD (N,N'-Bis(naphthalen-1-yl)-N,N'-bis(phenyl)-benzidine) doped with F4TCNQ.

Typical examples of doped electron transport materials are: fullerene C60 doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis ( 1,3,4,6,7,8 - hexahydro - 2H - pyrimido [1,2 - a] pyrimidinato) ditungsten (II) (W(hpp)4); naphthalene tetracarboxylic acid di-anhydride (NTCDA) doped with 3,6-bis-(dimethyl amino)-acridine; NTCDA doped with bis(ethylene-dithio) tetrathiafulvalene (BEDT-TTF).

### OTFT

The inventive organic electronic device also allows the provision of improved organic thin film transistors (OTFT). This requires an injection layer between the source electrode and the semiconducting layer, and between the drain electrode and semiconducting layer. In such an OTFT the injection layer may be the substantially organic layer comprising the chemical compound according to formula (I) or (II). In this regard, it is preferred that the substantially organic layer is a pure layer of the chemical compound according to formula (I) or (II), more preferably in direct contact to the drain and source, i.e. no other layers inbetween. Such a layer can be interrupted (only under the electrodes) or not (unstructured). Because the lateral displacement of drain and source electrode is very small, the injection layer needs to be patterned with high precision. This constrain is relaxed with the use of non-patterned injection layers, however, common non-patterned injection layers also cover the semiconducting layer in the channel region, which may dope the channel region and may have the undesired effect to increase the off current of the transistor.

It was found that such an undesired effect does not occur for inventive organic electronic devices, due to high HOMO-LUMO energy gap they do not disturb or modify the electrical properties of the semiconductor. Due to the contact to the source and drain electrodes, a good injection layer is provided. This effect is enhanced if the source and drain electrodes are deposited over the injection layer. Therefore, it is preferred to use an injection layer comprising the chemical compound according to formula (I) or (II), wherein the injection layer is formed between the electrodes and the semiconductor and is unpatterned in the region between source and drain. The preferred thickness of such an injecting layer is below 5 nm.

In addition, or alternatively, the substantially organic layer can be used as a thin layer between the dielectric and the semiconductor,

In addition, or alternatively, the semiconductor layer can comprise small concentrations of the chemical compound (I), preferably less than 30 mol-% or preferably less than 10 mol-%. Preferably, the semiconducting layer and the inventive compound are in a layer as a homogeneous mixture.

Additional features and advantages of the present invention can be taken from the following detailed description of preferred embodiments, taken together with the drawing in which
Fig. 1 illustrates a first embodiment of an inventive organic electronic device;
Fig. 2 illustrates a second embodiment of an inventive organic electronic device; and
Fig. 3 shows a third embodiment of an inventive organic electronic device.

### Synthesis of the chemical compound according to formula (I) or (II)

In the following examples for synthesizing the chemical compound according to formula (I) or (II) the definition of X, Y, R and M applies only for the general synthesis route disclosed in this chapter. The definition given in the examples do not correspond to the definitions of X₁-X₁₀, Y, R and R₁ as given in the claims and shall not be mixed.

For example, for the general synthetic procedure of compounds (1)-(10), X can be selected from hydrogen or methyl. Having the definition of the chemical compound according to formula (I) or (II) in general in mind, it is clear that X of this general synthetic procedure corresponds to R according to formula (I) or (II). Of course, R according to formula (I) or (II) can still be selected from H, linear or branched alkyl, aryl and heteroaryl, thus is not restricted to H and methyl only. The same applies for the other definitions according to formula (I) or (II).

### Scheme 1, n = 1, Y = CR, compounds (1)-(10)

Chemical compounds according to formula (I) or (II) with n = 1 and Y = CR can be prepared as follows:

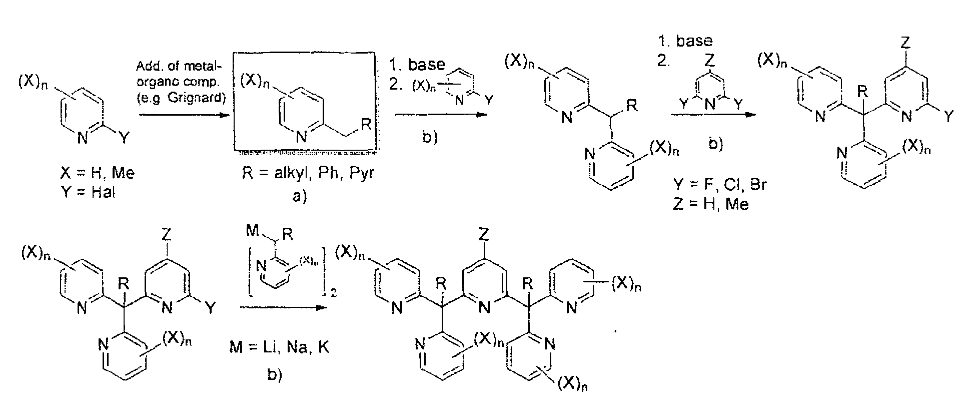

### Scheme 2, n = 1; Y = N, compounds (11)-(13)

Chemical compounds according to formula (I) or (II) with n = 1 and Y = N can be prepared as follows:

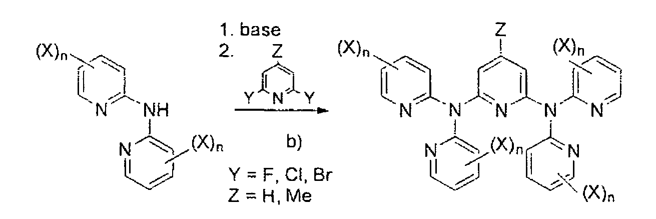

### Scheme 3, n = 1; Y = SiR, compounds (14)-(22)

Compounds according to the formula (I) with n = 1 and Y = SiR can be prepared as follows:

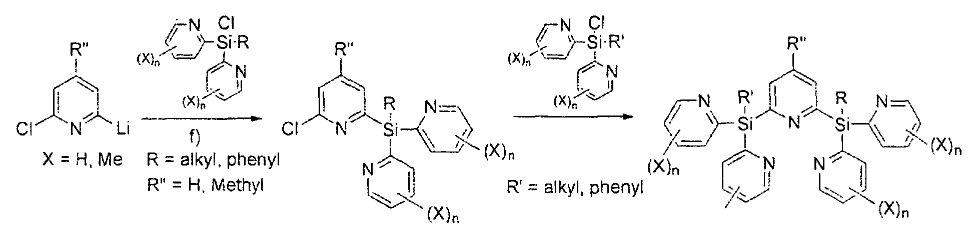

The general synthetic route can be based on scheme 1. Alternatively, bis-lithium pyridine can be utilized for the synthesis of symmetrical compounds.

Any further compounds according to formula (I) or (II), including the compounds with n=2, can be prepared by slightly amended reaction schemes as will be aware by someone skilled in the art.

### Organic electronic devices

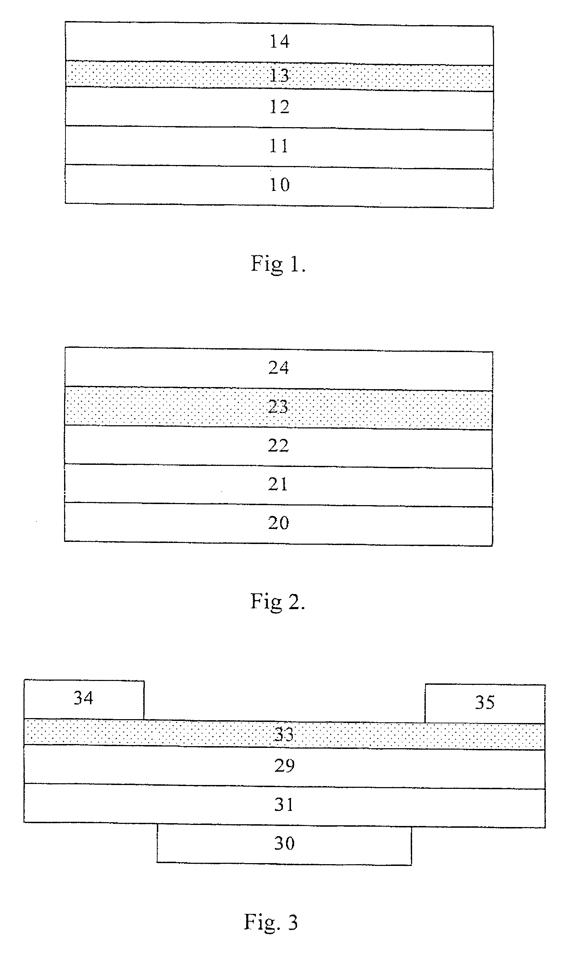

Fig. 1 illustrates a first embodiment of an inventive organic electronic device in the form of a stack of layers forming an OLED or a solar cell. In Fig. 1, 10 is a substrate, 11 is an anode, 12 is an EML or an absorbing layer, 13 is a EIL, 14 is a cathode.

The layer 13 can be a pure layer of a compound according to formula (I) or (II), alternatively it can also comprise a metal, which metal can also be used in the cathode material. At least one of the anode and cathode is at least semi-transparent. Inverted structures are also foreseen (not illustrated), wherein the cathode is on the substrate (cathode closer to the substrate than the anode and the order of the layers 11-14 is reversed). In this case, it is preferred that the layer 13 also comprises a metal. The stack may comprise additional layers, such as ETL, HTL, etc.

Fig. 2 represents a second embodiment of the inventive organic electronic device in the form of a stack of layers forming an OLED or a solar cell. Here, 20 is a substrate, 21 is an anode, 22 is an EML or an absorbing layer, 23 is an ETL, 24 is a cathode. The layer 23 comprises an electron transport matrix material and a compound according to formula (I) or (II). In addition, layer 23 may also comprise a metal.

Fig. 3 illustrates a third embodiment of the inventive device in the form of an OTFT, with a semi-conductor layer 32, a source electrode 34 and a drain electrode 35. An unpatterned (unpatterned inbetween the source and drain electrodes) injection layer 33 provides charge carrier injection and extraction between the source-drain electrodes and a semi-conducting layer. OTFT also comprises a gate insulator 31 (which could be on the same side as the source-drain electrodes) and a gate electrode 30, which gate electrode 30 is on the side of the layer 31 which is not in contact with the layer 32. Obviously the whole stack could be inverted. A substrate may also be provided, or alternatively, the insulator layer 31 may be the substrate.

The following examples were prepared utilizing always the same compound to enable direct comparison of the performance. Of course, any compound according to formula (I) or (II) can be used. On sets of experiments realized in batches of parallel organic electronic devices, it was found that all compounds according to formula (I) or (II) in a substantially organic layer of an organic electronic device provided an increased performance.

For all examples in the following, the chemical compounds below were used:

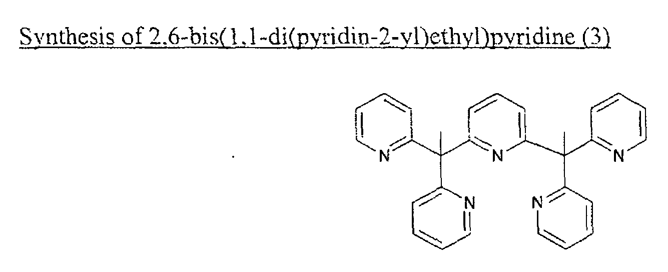

### 2,2'-(ethane-1,1-diyl)dipyridine

2-Ethylpyridine (20g, 0.19 mol) was dissolved in 300 ml of water-free tetrahydrofuran and cooled down to -80°C. 82.1 ml of n-butyl lithium (0.21 mol; 2.5 M solution in hexane) were added drop-wise and the mixture was allowed to warm up to -30°C over a period of 90 minutes. After that 2-fluoropyridine (13.6 ml, 0.19 mol) was added quickly and the solution was allowed to warm up to room temperature over a period of 2.5 hours. Then 100 ml of water were added to the reaction and the THF/water mixture was removed under reduced pressure nearly up to dryness. The residue was dissolved in 150 ml of saturated ammonium chloride solution and extracted three times with ethyl acetate. After drying the organic solvent has been removed under reduced pressure to afford 20.1 g (58%) of a brown colored crude product. The crude product was purified via vacuum distillation. The resulting product was a slowly solidifying, yellowish colored liquid. 10g gave after distillation 7.86g product (46% overall yield).

### 2,6-bis(1,1-di(pyridin-2-yl)ethyl)pyridine

To a solution of 2,2'-(ethane-1,1-diyl)dipyridine (7.0 g; 38.0 mmol) in 80 ml of tetrahydrofuran was added slowly a solution of 7.52 g (41.0 mmol) sodium hexamethyl disilamide. The resulting mixture was kept under stirring at room temperature for 90 min. Afterwards difluoropyridine (1.39 ml; 15.2 mmol) was added in one crop and the mixture heated up to 90°C for five days. After the reaction was finished, the mixture was allowed to cool down to room temperature and 70 ml of water were added. The solvents were removed under reduced pressure nearly up to dryness. Then 100 ml of dichloromethane and 35 ml of water were added. The layers were separated and the aqueous layer was extracted two times with dichloromethane (60 ml). The combined organic layers were washed again with 140 ml of water and the solvent was removed under reduced pressure. The crude product was purified by crystallization from a mixture of ethyl acetate and hexane to give 3.28 g (48%)of 100% pure GC-MS quality. Mp.= 148°C.

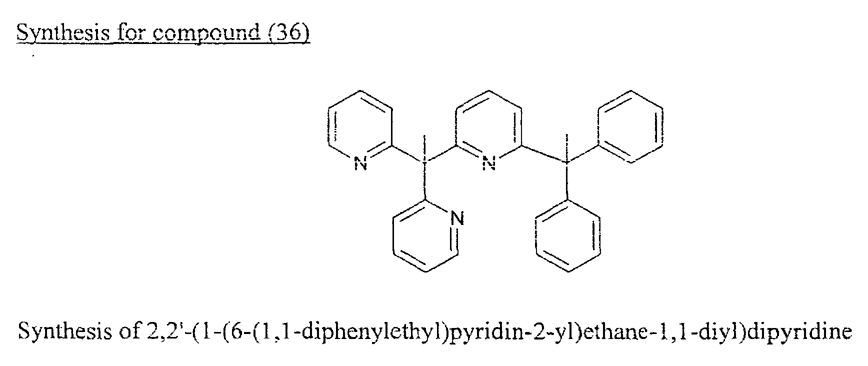

### 2,2'-(ethane-1,1-diyl)dipyridine

2-ethylpyridine (58 g, 540 mmol) was dissolved in tetrahydrofurane (550 mL) and cooled to ― 80°C. 200 mL (540 mmol) of *n*-butyl lithium (2.7 M in *n*-heptane) were added. After stirring at -20°C for two hours 2-fluoropyridine (26.3 g, 270 mmol) was added. The mixture was shortly stirred under reflux, then cooled and poured on ice water. The layers were separated and the aqueous layer was extracted with dichloromethane. The combined organic layers were dried with sodium sulphate and concentrated under reduced pressure. The oily residue was distilled under reduced pressure to yield 39.8 g (80%) of a yellow oil that was used in the next synthesis step without any further purification.

### 2,2'-(1-(6-fluoropyridin-2-yl)ethane-1,1-diyl)dipyridine

26.8 g of 2,2'-(ethane-1,1-diyl)dipyridine (145 mmol) were dissolved in 400 mL of tetrahydrofurane. A solution of 32 g of potassium hexamethyldisilazide (160 mmol) in 240 mL of tetrahydrofurane was added. After stirring for one hour 16.8 g of 2,6-difluoropyridine (145 mmol) were added. The mixture was heated under reflux for a little while. After cooling down to room temperature saturated aqueous ammonium chloride solution was added and the solvent was removed under reduced pressure. The residue was dissolved in sufficient amounts of ethyl acetate and water, the layers were separated and the aqueous layer was extracted with ethyl acetate. The combined organic layers were washed with brine, dried with sodium sulphate, filtrated and concentrated. Overnight stirring of the residue in *tert*-butyl methyl ether and filtration as well as drying afterwards gave 36.6 g (90%) of a white powder, which was used in the next synthesis step without any further purification.

### Ethane-1,1-diyldibenzene

A mixture of 20 of 1,1-diphenylethanol (101 mmol) and 25.6 g of iodine (101 mmol) in 100 mL of glacial acetic acid was stirred at ambient temperature for 20 minutes. Afterwards 52 mL of aqueous hypophosphorous acid (33.3 g H₃PO₂, 505 mmol) were added dropwise to the stirred mixture. After the exothermic addition was completed, the mixture was stirred at 55°C for 24 hours. Water was added and the mixture was extracted five times with *n*-hexane. The combined organic layers were washed with water, dried with magnesium sulphate and the solvent was removed under reduced pressure at room temperature to yield 18.2 g (99 %) of a colourless liquid. Purification of the crude product was performed by gel filtration on silica gel using *n*-hexane as solvent, followed by vacuum distillation. 14.0 g (82 %) of a colourless liquid were obtained and used in the next synthesis step.

### 2,2'-(1-(6-(1,1-diphenylethyl)pyridin-2-yl)ethane-1,1-diyl)dipyridine

In a pressure vessel a solution of 1.0 g of ethane-1,1-diyldibenzene (5.49 mmol) in 5 mL of tetrahydrofurane was treated in portions with 1.2 g of potassium hexamethyldisilazane (6.04 mmol) under vigorously stirring. Another 5 mL of tetrahydrofurane were added, the vessel was sealed and the mixture was stirred at ambient temperature for one hour. Afterwards 1.53 g of 2,2'-(1-(6-fluoropyridin-2-yl)ethane-1,1-diyl)dipyridine (5.49 mmol) were added successively in small portions and after addition of 5 mL of tetrahydrofurane the sealed vessel was heated to 90°C. The reaction was monitored by GC-MS and stopped after one week by addition of saturated aqueous ammonium chloride solution. The complete solvent was removed under reduced pressure and the remaining residue was washed with water. The remaining residue was dissolved in *tert*-butyl methyl ether and impurities were precipitated by addition of *n*-hexane. After separation of the solvent from the filtrate, the residue was washed with *n*-hexane and dried. The yellow, highly viscous oil (1.33 g, 55%) was dissolved in 100 mL of 2 N aqueous hydrochloric acid and extracted with chloroform. The combined organic layers were dried with magnesium sulphate and the solvent was removed cautiously under reduced pressure. The residue was washed several times with small amounts of *tert-*butyl methyl ether and dried again to give 580 mg (24%) of a white solid. Further purification of the crude product was performed by sublimation.

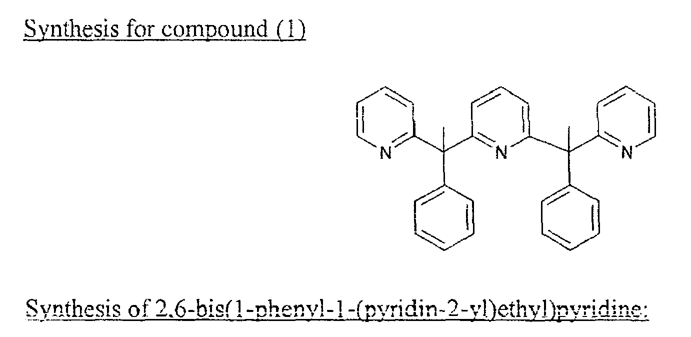

### 2-(1-phenylethyl)pyridine:

1.00 g of benzylpyridine (5.90 mmol) were dissolved in 20 mL tetrahydrofurane and cooled to -80°C. 4.1 mL (6.50 mmol) of *n*-butyl lithium (1.6 M in *n*-hexane) were added drop wise and the resulting solution was stirred for one hour at -50°C. 0.4 mL of iodomethane (6.5 mmol) were added afterwards. The mixture was stirred for one hour at ambient temperature and the reaction was stopped by adding a small amount of water. The solvent was removed under reduced pressure and the residue dissolved in 10 dichloromethane and 10 mL water. The aqueous layer was extracted once with 10 mL dichloromethane and the combined organic layers washed with water, dried with magnesium sulphate and the solvent removed. The crude product was a yellow oil, with a yield of 1.10 g (100%), which was used without further purification.

### 2,6-bis(1-phenyl-1-(pyridin-2-yl)ethyl)pyridine:

2.63 g of 2-(1-phenylethyl) pyridine (14.4 mmol) were dissolved in 40 mL of tetrahydrofurane and cooled to -80°C. 10.8 mL (17.3 mmol) of *n*-butyl lithium (1.6 M in *n*-hexane) were added drop wise and the resulting solution was stirred for one hour at -50°C. 0.51 mL of 2,6-difluoropyridine (5.6 mmol) were added at -60°C and the mixture was stirred at ambient temperature for a while. The reaction was stopped by adding water to the solution. The solvent was removed and the residue dissolved in dichloromethane and water. The aqueous layer was extracted with dichloromethane. The combined organic layers were washed with water and dried with magnesium sulphate. After the solvent was removed, the crude product was purified by column chromatography using ethyl acetate and hexane as solvents to yield 2.27 (92%).

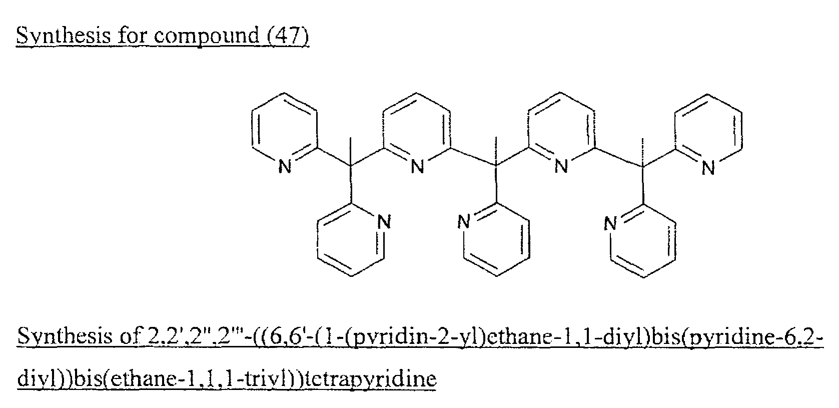

### 6,6'-(1-(pyridin-2-yl)ethane-1,1-diyl)bis(2-fluoropyridine)

13.8 g (129 mmol) of 2-ethylpyridine were dissolved in 220 mL of tetrahydrofurane and cooled to -80°C. 100 mL (270 mmol) of butyl lithium (2.7 M solution in heptane) were added. After warming up the mixture to -50°C a solution of 13.6 mL (257 mmol) 2,6-difluoropyridine in 190 mL of THF was added. The mixture was kept under reflux for four hours. After cooling down the mixture was quenched with a solution of saturated ammonium chloride and the organic solvent was removed under reduced pressure. 500 mL of diethyl ether and 300 mL water were added to the residue and the aqueous layer was washed with ethyl acetate. The combined organic layers were washed with a solution of saturated sodium chloride, dried with sodium sulphate, then filtrated and concentrated. The residue was washed twice with isopropanol and then filtrated. The mother liquor was concentrated, stored at 0°C overnight and filtrated. The residue was washed with small amounts of isopropanol and the combined solids were dried again. 19.3 g (51%) of the desired product were obtained as a slightly yellow coloured solid that was used in the next synthesis without further purification.

### 2,2'-(ethane-1,1-diyl)dipyridine: preparation see above

### 2,2',2'',2'''-((6,6'-(1-(pyridin-2-yl)ethane-1,1-diyl)bis(pyridine-6,2-diyl))bis-(ethane-1,1,1-triyl))tetrapyridine

7.44 g (40 mmol) of 2,2'-(ethane-1,1-diyl)dipyridine were dissolved in 40 mL of dimethoxyethane. 8.33 g (45 mmol) of sodium-bis-(trimethylsilyl)amide were dissolved in 30 mL dimethoxyethane and added slowly. After stirring for one hour at room temperature 3.00 g (10.0 mmol) of 6,6'-(1-(pyridin-2-yl)ethane-1,1-diyl)bis(2-fluoropyridine) in 30 mL of dimethoxyethane were added and the mixture was stirred at 100°C for two days. After cooling at room temperature saturated ammonium chloride solution, ethylacetate and water were added successively and the remaining mixture was extracted with ethyl acetate. The organic layer was dried with sodium sulphate, filtrated and concentrated. After distillation 4.76 g (7.60 mmol) of the desired product were obtained as a brown solid. The compound was further purified by gradient sublimation.

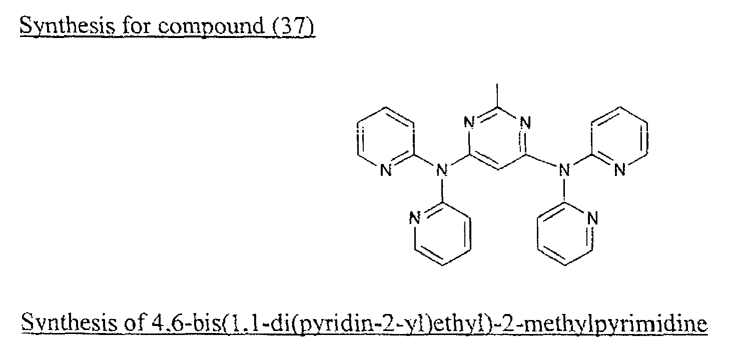

### 2,2'-(ethane-1,1-diyl)dipyridine: preparation described above

### 4,6-bis(1,1-di(pyridin-2-yl)ethyl)-2-methylpyrimidine:

To a solution of 2,2'-(ethane-1,1-diyl)dipyridine (11.3 g; 61.4 mmol) in 100 mL of tetrahydrofurane was added slowly a solution of 11.8 g (64.5 mmol) sodium hexamethyl disilamide in 30 mL of tetrahydrofurane. The resulting mixture was kept under stirring at room temperature for 60 min. Afterwards a solution of 4,6-dichloro-2-methylpyridine (5 g; 30.7 mmol) in 30 mL tetrahydrofuran was added drop wise and the mixture was stirred at ambient temperature over night. After the reaction was finished, the solvent was removed under reduced pressure. The residue was dissolved in ethyl acetate and saturated aqueous ammonium hydrochlorid solution. The aqueous layers was extracted with 120 mL of ethyl acetate and the combined organics layers were washed with brine and the solvent removed under reduced pressure. The crude product was suspended in 200 mL of diethyl ether and some drops of ethyl acetate and then stirred for one hour. The mixture was filtrated and the solid residue washed with diethyl ether and hexane. The solid was dried to give 9.35 g (67%) which were further purified by gradient sublimation.

### Example 1. OLED with injection layer

An OLED was prepared with the following layer structure on a glass substrate:
a. 90 nm ITO as anode
b. 2 nm F4-TCNQ (tetrafluorotetracyanoquinodimethane)
c. 40 nm α-NPD (N,N'-Bis(naphthalen-1-yl)-N,N'-bis(phenyl)-benzidine)
d. 20 nm blue emitter system
e. 40 nm 2,9-di(biphenyl-4-yl)-4,7-diphenyl-1,10-phenanthroline
f. 2 nm layer of compound (3)
g. 100 nm A1 as cathode

Also an electrode of 50 nm Mg with a cap layer of 50 nm Al was used with almost identical results. The results are similar as using an n-dopant interlayer such as W(hpp)2 in place of layer f. A current efficiency of 12 cd/A was measured at 1000 cd/m2, and a quantum efficiency of 6.9 %. The voltage was as low as 3.6 V at 10 mA/cm2.

Comparative devices were fabricated without layer (f) and modifying the thickness of layer (e) to 42 nm. Other comparative devices were fabricated replacing layer f) with 2 nm bathophenanthrolin (BPhen). Both types of comparative devices showed extremely poor performance; the voltage for a current density of 1 mA/cm2 was over 10 V.

Other comparative devices were made replacing the layer f by 15-([1,1'-biphenyl]-4-yl)-2,3,5,6,8,9,11,12-octahydrobenzo[b][1,4,7,10,13]pentaoxacyclopentadecine, the OLED did had very low performance, and the voltage for a current density of 1 mA/cm2 was still over 7 V.

The inventive OLED shows a lower operating voltage and a higher power efficiency showing that the injection layer of the inventive device is not simply a buffer layer. Similar devices were made replacing compound (3) by any of compounds (37), (24), and (47), those devices show almost equivalent performance in terms of low voltage.

### Example 2

An OLED was made according to example 1 with compound (3), wherein the injection layer was made 2 nm thick and formed by co-evaporating compound (3) and Mg with a weight ratio 5% (Mg in compound). A comparative OLED was made with the same device structure without an injection layer but with a 2 nm thicker ETL. The inventive OLED had considerable better performance, similar to the inventive device in example 1, wherein the comparative OLED only showed a current density of 1mA/cm2 at 10 V.

### Example 3

An OLED was made with the following layer structure on a glass substrate:
a. 100 nm Ag as anode
b. 110 nm of α-NPD doped with 5% 2,2'-(perfluoronaphthalene-2,6-diylidene)dimalononitrile
c. 30 nm of α-NPD
d. 20 nm blue emitter system
e. 30 nm 2,9-di(biphenyl-4-yl)-4,7-diphenyl-1,10-phenanthroline doped with compound (30) (5 wt%)
f. 15 nm Mg (with 10 vol% of Ag) as cathode

The device had a very low voltage at 10 mA/cm2 of only 3.6V, and a current efficiency of about 4.7 cd/A.

Another device was made with a concentration of 20wt% in layer e. with similar results as the device above.

Another device was made adding a 2 nm layer of compound (3) between layers e. and f. An additional small decrease in the voltage was observed (0,2 V).

The inventive OLED had extremely improved performance as compared to the comparative device in example 2. Similar devices were made replacing compound (3) by any of compounds (37), (24), and (47), those devices show almost equivalent performance in terms of low voltage.

### Example 4

An OLED was made with the following layer structure on a glass substrate:
a. 90 nm ITO as anode
b. 2 nm 2,2'-(perfluoronaphthalene-2,6-diylidene)dimalononitrile
c. 40 nm of α-NPD
d. 20 nm blue emitter system
e. 10 nm 2,9-di(biphenyl-4-yl)-4,7-diphenyl-1,10 -phenanthroline
f. 40 nm of a matrix 2,9-di(biphenyl-4-yl)-4,7-diphenyl-1,10-phenanthroline doped with compound 3 and Mg with the following concentration 75:5:20 wt% (matrix:Mg:compound (3))
g. 100 nm Al as cathode

The OLED showed a low voltage of only 3.2 V at 10mA/cm2 and a current efficiency over 10 cd/A. Another device was made with the same stack however as inverted structure, (the cathode formed first, and closer to the substrate than the anode).

### Example 5

An OLED was made according to example 4 wherein an additional layer with a thickness of 5 nm comprising compound (3) and Mg with a weigth ratio 1:5 (Mg: compound (3)) was formed between the ETL and the cathode. The OLED had a slightly increased power performance compared to the example 3 and a small increase in lifetime.

### Solar cells

### Example 6 - organic solar cell with injection layer

An organic solar cell was fabricated with the following procedure: patterned glass substrate coated with ITO was cleaned in an ultrasound bath with ethanol, acetone and isopropanol. Afterwards the ITO substrate was exposed to oxygen plasma treatment for 15 minutes. The substrate was loaded into the vacuum trough of a glove box with nitrogen. In vacuum the organic layers were deposited with conventional VTE (vacuum thermal evaporation). First a 10 nm thick 5% (molar) p-doped ZnPc (Zinc phthalocyanine) layer was deposited through a shadow mask over the ITO. A 10 nm undoped ZnPc layer was deposited over the doped ZnPc layer. A 30 nm thick mixed layer of fullerene C60 and ZnPc was deposited with a molar ratio of 2(C60):1(CuPc). A 40 nm thick C60 layer was deposited on top of the mixed layer. An injection layer of 2,5 nm (compound 47) layer was deposited on top of the C60 layer. The compound (47) layer is followed by a 100 nm thick Al cathode. Although under normal operation, the cathode extracts electrons from the organic semiconducting layer, the solar cell still has a conventional diode behavior in dark and also under forward bias; therefore the compound (47) layer is still called an injection layer.

In a comparative example, the ETL was made thicker by 2,5 nm and no injection layer was used. In another comparative example, an organic solar cell was made according to the example 6, however the injection layer was replaced by a BPhen buffer layer with thickness of 2,5 nm. The inventive organic solar cell shows a lower operating voltage and a higher power efficiency showing that the injection layer according to the invention is not simply a buffer layer.

### Example 7

An organic solar cell was made according to example 6, wherein the injection layer was made 2,5 nm thick and formed by co-evaporating compound compound (47) and Mg with a weigth ratio 5:1 (compound (47):Mg). A comparative organic solar cell was made with the same device structure without an injection layer but with a 2,5 nm thicker ETL. The inventive organic solar cell had considerable better field factor (FF) and considerably better performance.

### Example 8

An organic solar cell was made according to example 7, however without any injection layer, and the compound (47) was mixed in the C60 layer with a final ratio of 1:20 (compound (47):C60), the C60 layer was made 2,5 nm thicker (42,5 nm) to allow comparison with example 7.

The organic solar cell was compared to the comparative device in example 7. The inventive organic solar cell had improved power performance.

### Example 9

An organic solar cell was made according to example 8 wherein the ETL was formed by a triple evaporation of ETL, compound (47), and Mg with a molar ratio of 10:1:1 (ETL,compound (47),Mg). The organic solar cell had an increased power performance compared to the example 8.

### Example 10

An organic solar cell was made according to example 9 wherein an additional layer with a thickness of 2 nm comprising of compound compound (47) and Mg with a doping weight ratio 5:1 (compound (47):Mg) was formed between the ETL and the cathode. The organic solar cell had a slight increased power performance compared to the example 8 and also a increase in lifetime. A similar device was made replacing compound (47) by compound (3), which device shows equivalent power conversion efficiency.

### Example 13 - OTFT

An ITO layer was formed on a glass substrate as a gate electrode. Subsequently an 800 nm thick PMMA layer was formed by spin-coating a solution on the ITO layer to serve as gate insulator. A 50 nm thick pentacene layer was deposited over the gate insulator by VTE. An unpatterned injection layer of 3 nm compound (3) was deposited over the pentacene layer by VTE, and the source and drain electrodes made of Al were deposited on top of the injection layer. The channel length was 3 mm and its width was 50 µm. A comparative example was made using F4TCNQ as unstructured injection layer, the comparative example had a more than 15x increased off current, and a 10x smaller on/off ratio compared to the inventive device. A comparative example without any injection layer was also made having an off current similar to the inventive device but a 100x smaller on/off ratio.

### Example 14 - Solution processing

A polymer OLED was made with the following device structure on an ITO pre coated glass substrate:
- 40 nm spin-coated PEDOT-PSS
- 60 nm of a polyfluorene derivative (spin coated)
- 2 nm of compound (3)
- Mg (10 nm) / A1 (100 nm)

A comparative device without the compound (3) layer showed inferior performance than the inventive device.

In a separated test it was found that layers of the inventive devices can be made by ink-jet printing.

### Example 15

A pn junction device was made with the following device structure:
a. 90 nm ITO as anode
b. 50 nm of 2,9-di(biphenyl-4-yl)-4,7-diphenyl-1,10-phenanthroline
c. 2 nm layer of compound (3)
d. 2 nm of Al
e. 50 nm α-NPD (N,N'-Bis(naphthalen-1-yl)-N,N'-bis(phenyl)-benzidine) 6 mol% doped with 2,2',2''-(cyclopropane-1,2,3-triylidene)tris(2-(p-cyanotetrafluorophenyl)acetonitrile)
f. 40 nm α-NPD
g. 100 nm Al as cathode

The forward voltage at a current density of 10 mA/cm2 was about 6 V. Similar results were obtained by replacing the compound on layer (b.) by any of 3-(4-Biphenylyl)-4-phenyl-5-tert-butylphenyl-1,2,4-triazole, 4-(naphthalen-1-yl)-2,7,9-triphenylpyrido[3,2-h]quinazoline, and 2,9-di(naphthalen-1-yl)-4,7-diphenyl-1,10-phenanthroline.

## Claims

1. Organic electronic device comprising at least one substantially organic layer comprising a chemical compound according to formula (1) 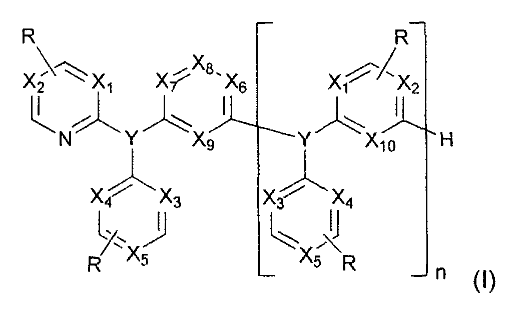 wherein n is an integer of from 1 to 5, preferably 1 to 2;
each X₁-X₇ is independently selected from N and CR;
X₈ is N or CR';
X₉ is N or CH;
X₁₀ is N or CH;
each Y is independently selected from N, CR and SiR; and
each R is independently selected from H, linear and branched alkyl, preferably C₁-C₆-alkyl, aryl, preferably C₆-C₂₀-aryl, and heteroaryl, preferably C₅-C₂₀ heteroaryl;
R' is selected from H, linear and branched alkyl, preferably C₁-C₆-alkyl, and aryl, preferably C₆-C₂₀-aryl;
and, in case Y is CR, R is different from H,
wherein the organic electronic device comprises a layered structure including a substrate, an anode and a cathode, the at least one substantially organic layer being disposed within the layered structure between the anode and the cathode and the substantially organic layer has an interface with the cathode;
or
the substantially organic layer is present in a pn junction, the pn junction having at least two layers, namely a p- and n-layer, and optionally an interlayer i in between, wherein the interlayer i and/or the n-layer is (are) the substantially organic layer.

2. Organic electronic device according to claim 1, wherein the substantially organic layer comprises at least one metal or a metal ion, preferably interacting with the chemical compound according to formula (I), wherein the metal or metal ion is selected from Ag, Al, Mg, Ba, Ca, Yb, In, Zn, Sn, Sm, Bi, Eu, Li preferably from Al, Mg, Ca, Ba, even more preferably from Al or Mg.

3. Organic electronic device according to claim 1, wherein the cathode is a top electrode and the anode is a bottom electrode, wherein the bottom electrode is closer to the substrate than the top electrode.

4. Organic electronic device according to any of the preceding claims, wherein the substantially organic layer further comprises an electron transport material.

5. Organic electronic device according to claim 4, wherein the electron transport material is selected from: 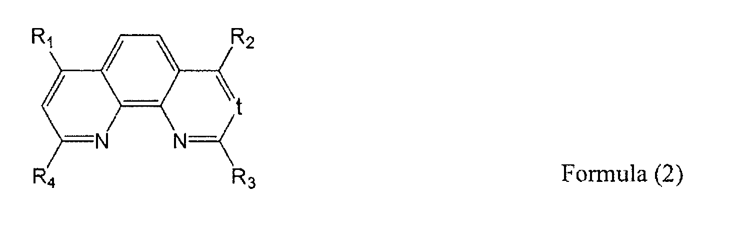
- wherein R1 - R4 are independently selected from H, C1-C20-Alkyl, branched C4-C20-alkyl or C3-C20-cycloalkyl, G1-C20 alkenyl, C1-C20 alkinyl, aryl preferably selected from phenyl, tolyl, biphenylyl, naphthyl, or heteroaryl preferably selected from pyridyl, pyrimidinyl, quinolinyl, pyrazinyl, thiophenyl, Furanyl, benzothiophenyl, benzofuranyl;
- wherein the structural element t is selected from CH, CR1, N, CCN.

6. Organic electronic device according to any of the preceding claims, additionally comprising a polymer semiconducting layer.

7. Organic electronic device according to any of the preceding claims, wherein the organic electronic device is a solar cell or a light emitting diode.

8. Organic electronic device according to any of the preceding claims, wherein the organic electronic device is a field effect transistor comprising a semiconducting channel, a source electrode, and a drain electrode, the substantially organic layer being provided inbetween the semiconducting channel and at least one of the source electrode and the drain electrode.

9. Organic electronic device according to any of the preceding claims, wherein the substantially organic layer comprising the chemical compound according to formula (I) is an electron injection layer and/or a n-doped electron transport layer.

10. Process for preparing an organic electronic device according to any of the preceding claims, wherein the substantially organic layer comprising a chemical compound according to formula (I) is deposited on a first other layer, and a second other layer is deposited on the substantially organic layer, a cathode being deposited on the substantially organic layer comprising the chemical compound according to formula (I).

11. Process according to claim 10, wherein the substantially organic layer is evaporated, preferably co-evaporated with metal and/or electron transport material.

12. Compound according to formula (II) 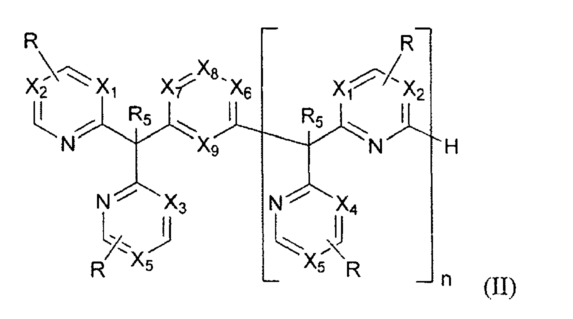 wherein
each X₁-X₇ is independently selected from N and CR, preferably X₇ and X₆ = CH;
X₈ is independently selected from N and CR₆, with R₆ independently selected from linear and branched alkyl, preferably C₁-C₆-alkyl, and aryl preferably C₆-C₂₀-aryl;
X₉ is N or CH;
each R is independently selected from H, linear and branched alkyl, preferably C₁-C₆-alkyl, aryl, preferably C₆-C₂₀-aryl, and heteroaryl, preferably C₅-C₂₀ heteroaryl, preferably H; and
R₅ is alkyl, preferably preferably C₁-C₆-alkyl; and
n is an integer of from 1-5, preferably 1 or 2.

## Patentansprüche

1. Organische elektronische Vorrichtung umfassend wenigstens eine im wesentlichen organische Schicht umfassend eine chemische Verbindung nach Formel (I) 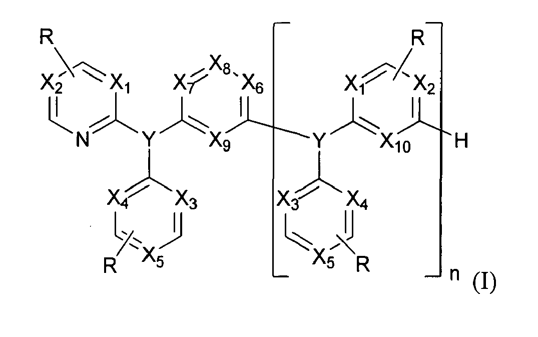 wobei n eine ganze Zahl von 1 bis 5, bevorzugt 1 bis 2 ist;
jedes X₁-X₇ unabhängig ausgewählt ist aus N und CR;
X₈ N oder CR' ist;
X₉ N oder CH ist;
X₁₀ N oder CH ist;
jedes Y unabhängig ausgewählt ist aus N, CR und SiR; und
jedes R unabhängig ausgewählt ist aus H, linearem und verzweigtem Alkyl, bevorzugt C₁-C₆-Alkyl, Aryl, bevorzugt C₆-C₂₀-Aryl und Heteroaryl, bevorzugt C₅-C₂₀-Heteroaryl;
R' ausgewählt ist aus H, linearem und verzweigtem Alkyl, bevorzugt C₁-C₆-Alkyl; und Aryl, bevorzugt C₆-C₂₀-Aryl;
und im Falle, dass Y CR ist, R von H verschieden ist,
wobei die organische elektronische Vorrichtung eine Schichtstruktur einschließend ein Substrat, eine Anode und eine Kathode umfasst, wobei die wenigstens eine im wesentlichen organische Schicht innerhalb der Schichtstruktur zwischen der Anode und der Kathode angeordnet ist und die im wesentlichen organische Schicht eine Grenzfläche mit der Kathode aufweist;
oder
die im wesentlichen organische Schicht in einer pn-Junction vorhanden ist, wobei die pn-Junction wenigstens zwei Schichten, nämlich eine p- und n-Schicht, aufweist und optional eine Zwischenschicht i dazwischen, wobei die Zwischenschicht i und/oder die n-Schicht die im wesentlichen organische Schicht ist bzw. sind.

2. Organische elektronische Vorrichtung nach Anspruch 1, wobei die im wesentlichen organische Schicht wenigstens ein Metall oder ein Metallion umfasst, bevorzugt wechselwirkend mit der chemischen Verbindung nach Formel (I), wobei das Metall oder Metallion ausgewählt ist aus Ag, Al, Mg, Ba, Ca, Yb, In, Zn, Sn, Sm, Bi, Eu, Li, bevorzugt aus Al, Mg, Ca, Ba, noch bevorzugter aus Al oder Mg.

3. Organische elektronische Vorrichtung nach Anspruch 1, wobei die Kathode eine Top-Elektrode und die Anode eine Bottom-Elektrode ist, wobei die Bottom-Elektrode näher am Substrat als die Top-Elektrode ist.

4. Organische elektronische Vorrichtung nach einem der vorangehenden Ansprüche, wobei die im wesentlichen organische Schicht ferner ein Elektronentransportmaterial umfasst.

5. Organische elektronische Vorrichtung nach Anspruch 4, wobei das Elektronentransportmaterial ausgewählt ist aus: 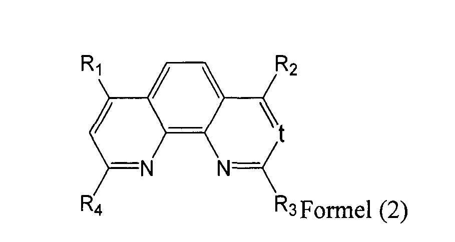
- wobei R1-R4 unabhängig ausgewählt sind aus H, C₁-C₂₀-Alkyl, verzweigtem C₄-C₂₀-Alkyl oder C₃-C₂₀-Cycloalkyl, C₁-C₁₀-Alkenyl, C₁-C₂₀-Alkinyl, Aryl, bevorzugt ausgewählt aus Phenyl, Tolyl, Biphenylyl, Naphthyl, oder Heteroaryl, bevorzugt ausgewählt aus Pyridyl, Pyrimidinyl, Chinolinyl, Pyrazinyl, Thiophenyl, Furanyl, Benzothiophenyl, Benzofuranyl;
- wobei das Strukturelement t ausgewählt ist aus CH, CR1, N, CCN.

6. Organische elektronische Vorrichtung nach einem der vorangehenden Ansprüche, zusätzlich umfassend eine Polymerhalbleiterschicht.

7. Organische elektronische Vorrichtung nach einem der vorangehenden Ansprüche, wobei die organische elektronische Vorrichtung eine Solarzelle oder eine lichtemittierende Diode ist.

8. Organische elektronische Vorrichtung nach einem der vorangehenden Ansprüche, wobei die organische elektronische Vorrichtung ein Feldeffekttransistor umfassend einen Halbleiterkanal, eine Source-Elektrode und eine Drain-Elektrode ist, wobei die im wesentlichen organische Schicht zwischen dem Halbleiterkanal und wenigstens einer der Source-Elektrode und der Drain-Elektrode bereitgestellt ist.

9. Organische elektronische Vorrichtung nach einem der vorangehenden Ansprüche, wobei die im wesentlichen organische Schicht, die die chemische Verbindung nach Formel (I) umfasst, eine Elektroneninjektionsschicht und/oder eine n-dotierte Elektronentransportschicht ist.

10. Verfahren zum Herstellen einer organischen elektronischen Vorrichtung nach einem der vorangehenden Ansprüche, wobei die im wesentlichen organische Schicht, die eine chemische Verbindung nach Formel (I) umfasst, auf einer ersten weiteren Schicht abgeschieden wird, und eine zweite weitere Schicht auf der im wesentlichen organischen Schicht abgeschieden wird, wobei eine Kathode auf der im wesentlichen organischen Schicht, die die chemische Verbindung nach Formel (I) umfasst, abgeschieden wird.

11. Verfahren nach Anspruch 10, wobei die im wesentlichen organische Schicht verdampft wird, bevorzugt co-verdampft wird mit Metall und/oder Elektronentransportmaterial.

12. Verbindung nach Formel (II) 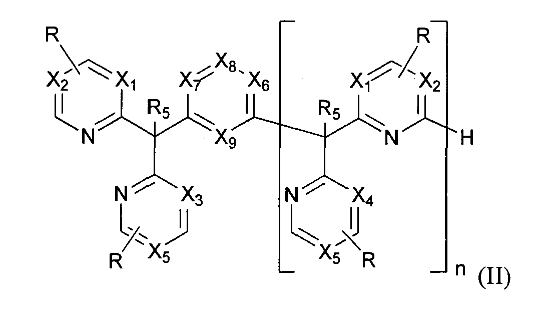 wobei
jedes X₁-X₇ unabhängig ausgewählt ist aus N und CR, bevorzugt X₇ und X₆ gleich CH sind;
X₈ unabhängig ausgewählt ist aus N und CR₆, wobei R₆ unabhängig ausgewählt ist aus linearem und verzweigtem Alkyl, bevorzugt C₁-C₆-Alkyl, und Aryl, bevorzugt C₆-C₂₀-Aryl;
X₉ N oder CH ist;
jedes R unabhängig ausgewählt ist aus H, linearem und verzweigtem Alkyl, bevorzugt C₁-C₆-Alkyl, Aryl, bevorzugt C₆-C₂₀-Aryl, und Heteroaryl, bevorzugt C₅-C₂₀-Heteroaryl, bevorzugt H; und
R₅ Alkyl ist, bevorzugt C₁-C₆-Alkyl; und
n eine ganze Zahl von 1-5, bevorzugt 1 oder 2 ist.

## Revendications

1. Dispositif électronique organique comprenant au moins une couche essentiellement organique comprenant un composé chimique selon la formule (I) 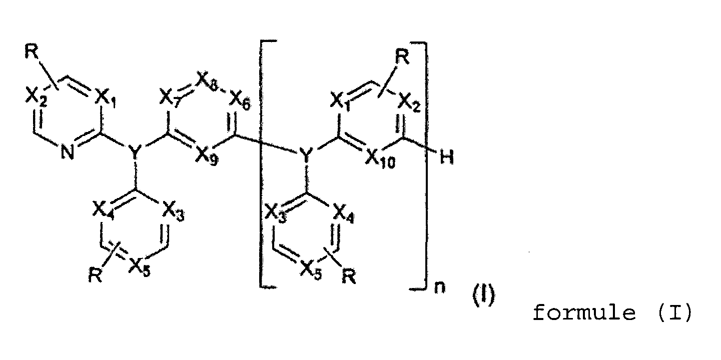 où n est un nombre entier de 1 à 5, de préférence 1 à 2 ;
chaqueX₁-X₇ est indépendamment choisi entre N et CR ;
X₈ est N ou CR' ;
X₉ est N ou CH ;
X₁₀ est N ou CH ;
chaque Y est indépendamment choisi entre N, CR et SiR ; et
chaque R est indépendamment choisis de H, linéaire et ramifié en alkyl, de préférence alkyle en C₁-C₆, aryle, de préférence aryle en C₆-C₂₀, et l'hetéroaryle, de préférence, l'hetéroaryle en C₅-C₂₀ ;
R' est choisi de H, un groupe alkyle, linéaire ou ramifié, de préférence l'alkyle en C₁-C₆, et l'aryle, de préférence l'aryle en C₆-C₂₀ ;
et, dans le cas où Y est CR, R est différent de H,
où le dispositif électronique organique comprend une structure en couches comprenant un substrat, une anode et une cathode, là au moins une couche essentiellement organique est disposée à l'intérieur de la structure en couches entre l'anode et la cathode et la couche essentiellement organique a une interface avec la cathode ;
ou
la couche essentiellement organique est présente dans une jonction pn, la jonction pn ayant au moins deux couches, à savoir une couche p et une couche n, et éventuellement une couche intermédiaire i entre les deux, où la couche intermédiaire I et/ou la couche n est (sont) la (les) couche(s) essentiellement organique (s) .

2. Dispositif électronique organique selon la revendication 1, où la couche essentiellement organique comprend au moins un métal ou un ion métallique, de préférence en interaction avec le composé chimique selon la formule (I), où le métal ou l'ion métallique est choisi de Ag, Al, Mg, Ba, Ca, Yb, In, Zn, Sn, Sm, Bi, Eu, Li, de préférence de Al, Mg, Ca, Ba, et encore plus préférentiellement de Al ou Mg.

3. Dispositif électronique organique selon la revendication 1, où la cathode est une électrode supérieure et l'anode est une électrode de fond, avec l'électrode inférieure plus proche du substrat que l'électrode supérieure.

4. Dispositif électronique organique selon l'une quelconque des revendications précédentes, où la couche essentiellement organique comprend en outre un matériau de transport d'électrons.

5. Dispositif électronique organique selon la revendication 4, où le matériau de transport d'électrons est choisi de : 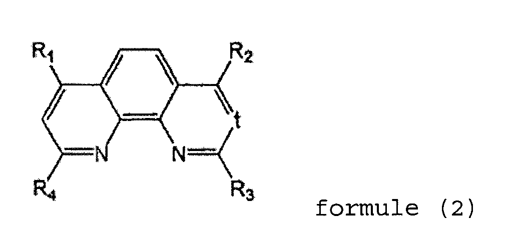
- où R1-R4 sont choisis indépendamment de H, alkyle en C1-C20, ramifié en C4-C20-alkyle ou C3-C20-Cycloalky], alcényle en C1-C20, alcynyle en C1-C20, aryle de préférence choisi parmi les groupes phényle, tolyle, biphénylyle , naphtyle ou hétéroaryle, de préférence choisi parmi les groupes pyridyle, pyriniidinyl, quinolinyle, pyrazinyle, thiophényle, furanyle, benzothiophényle, benzofuranyle ;
- où l'élément de structure t est choisi de CH, CR1, N, CCN.

6. Dispositif électronique organique selon l'une quelconque des revendications précédentes, comprenant en outre une couche semi-conductrice de polymère.

7. Dispositif électronique organique selon l'une quelconque des revendications précédentes, où le dispositif électronique organique est une cellule solaire ou une diode émettrice de lumière.

8. Dispositif électronique organique selon l'une quelconque des revendications précédentes, où le dispositif électronique organique est un transistor à effet de champ comportant un canal semi-conducteur, une électrode de source, et une électrode de drain, la couche essentiellement organique étant prévue entre le canal semi-conducteur et l'électrode de source et l'électrode de drain ou entre les deux.

9. Dispositif électronique organique selon l'une quelconque des revendications précédentes, où la couche essentiellement organique comprenant le composé chimique selon la formule (I) est une couche d'injection d'électrons et/ou une couche de transport d'électrons dopée de type n.

10. Procédé de préparation d'un dispositif électronique organique selon l'une quelconque des revendications précédentes, au cours duquel la couche essentiellement organique comprenant un composé chimique selon la formule (I) est déposée sur une première autre couche, et une deuxième autre couche est déposée sur la couche essentiellement organique , une cathode étant déposée sur la couche essentiellement organique comprenant un composé chimique selon la formule (I).

11. Procédé selon la revendication 10, au cours duquel la couche essentiellement organique est évaporée, de préférence co-évaporée avec du métal et / ou un matériau de transport d'électrons.

12. Composé selon la formule (II) 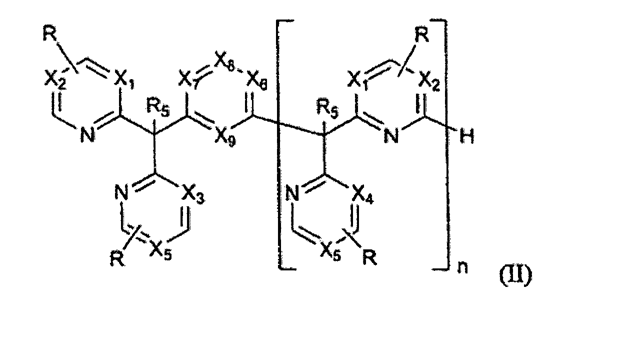 où
chaque X₁-X₇ est indépendamment choisi entre N et CR, de préférence X₇ et X₆ = CH ;
X₈ est indépendamment choisi entre N et CR₆, avec R₆ choisi indépendamment d'un groupe alkyle, linéaire ou ramifié, de préférence alkyle en C₁-C₆, et aryle de préférence aryle en C₆-C₂₀ ;
X₉ est N ou CH ;
chaque R est indépendamment choisis de H, linéaire et ramifié en alkyle, de préférence alkyle en C₁-C₆, l'aryle, de préférence aryle en C₆-C₂₀, et l'heteroaryle, de préférence l'heteroaryle en C₅-C₂₀, de préférence H : et
R₅ représente un groupe alkyle, de préférence, l'alkyle en C₁-C₆- ; et
n est un nombre entier de 1 à 5, de préférence 1 ou 2.
